# EUROPEAN PATENT SPECIFICATION

(11) **EP 1 724 640 B1**
(45) Date of publication and mention of the grant of the patent: **18.11.2015**
(21) Application number: 05719779.0
(22) Date of filing: 02.03.2005
(51) Int. Cl.: G03F 7/022

(54) **POSITIVE LIGHT-SENSITIVE RESIN COMPOSITION AND RELIEF PATTERN USING THE SAME**
POSITIV LICHTEMPFINDLICHE HARZZUSAMMENSETZUNG UND RELIEFMUSTER DAMIT
COMPOSITION DE RÉSINE PHOTOSENSIBLE POSITIVE ET MOTIFS EN RELIEF UTILISANT CELLE-CI

(30) Priority: 12.03.2004 JP 2004070229
(43) Date of publication of application: 22.11.2006
(73) Proprietor: TORAY INDUSTRIES, INC., Tokyo 103-8666 (JP)
(72) Inventor: SUWA, Mitsuhito, Otsu-shi, Shiga 5338437 (JP); MINAMIHASHI, Katsuya, Suginami-ku, Tokyo 167-0022 (JP)
(74) Representative: Kador & Partner
(86) International application number: PCT/JP2005/003464
(87) International publication number: WO 2005/088396

(56) References cited:
- WO-A1-03/065384
- JP-A- 5 323 599
- JP-A- 11 064 608
- JP-A- 2000 039 503
- JP-A- 2002 118 245
- JP-A- 2002 338 828
- JP-A- 2002 338 829
- JP-A- 2003 075 997
- JP-A- 2003 075 997
- JP-A- 2003 287 883

## Description

### [Technical field]

The invention relates to positive photosensitive resin compositions that become soluble in an alkaline solution when exposed to ultraviolet light, and that serve as material for optical waveguides and lenses for optical devices which are required to be high in transparency, refractive index, and quality of curvature.

### [Background art]

Said positive photosensitive resin compositions that become soluble in an alkaline solution when exposed to ultraviolet light include positive resist compositions, positive photosensitive polyimide precursor compositions, and positive photosensitive polybenzoxazole precursor compositions, all of which have already been developed (for instance, see patent reference 1) . These have been used as material for masks designed for silicon oxide film dry etching processes in semiconductor manufacturing plants, or theymaybeheated, or processed with a suitable catalyst, toproduce heat-resistant resin to be used in semiconductor's surface protection film, interlayer insulators, insulating layers in organic electroluminescence devices, etc (forinstance, seepatent reference 2). Said resin compositions generally do not have a sufficiently high index of refraction as material for lenses of optical devices, and products consisting of high transparency polyimide incorporating particles with a high refractive index have been developed to solve this problem (for instance, see patent reference 3).
[Patent reference 1]
   Unexamined Patent Publication (Kokai) 2002-241611
[Patent reference 2]
   Unexamined Patent Publication (Kokai) 2002-221794
[Patent reference 3]
   Unexamined Patent Publication (Kokai) 2003-75997

### [Disclosure of the invention]

### [Problems to be solved by the invention]

When applying to lenses of a charge coupled device, which is a kind of optical device, however, currently available products, which are generally low in refractive index, can cause troubles in producing products with a high pixel density and a highly fine pattern wiring which represent the current technological trends. Currently, a pattern is formed inacomposition, followed by thermal melting to produce lenses, but if a large amount of particles with a high refractive index is used to improve the refractive index of the product, these particles will disturb the flow of the material during heating, making it difficult to provide lenses that have both a high refractive index and an accurate shape.

The object of the invention is to provide compositions that are almost insoluble in alkali developers before exposure but become highly soluble in alkali developers when exposed to ultraviolet light, and that can form a fine, high-resolution pattern, to serve for productions of lenses with a high transparency and a high refractive index to be used in optical devices.

### [Means of solving the problems]

Thus the invention relates to positive photosensitive resin composition as claimed in claim 1.

Furthermore, the relief pattern of heat-resistant resin of the invention comprises dots with a size of 1 µm to 10 µm arranged grid-like at intervals of 0.1 µm to 1.0 µm, wherein each dot has a light transmittance at 400 nm of 80% or more per µm and a taper angle of 55° or less.
The present invention also proposes various preferred embodiments.

### [Effect of the invention]

The invention provide a positive photosensitive resin composition with a high transparency and a high refractive index, which can be developed by an alkaline solution. It is also possible to form a relief pattern that serves to produce lenses with a preferred refractive index and an accurate shape to be used in solid-state image sensors such as charge coupled device.

### [Brief description of the drawings]

### [Figure 1]

This illustrates a process of producing a lens from a photosensitive resin composition of the invention. The left-hand picture shows the cross-section of a pattern produced by light exposure and development, while the right-hand picture shows the cross-section (in a lens shape) of a pattern produced by heating the former.

### [Key]

1 and 3: taper angle
2: substrate

### [Best mode for carrying out the invention]

Component (a) of the invention should be soluble in the alkaline solution used as developer, and any common alkali-soluble polymer that has been conventionally used may serve appropriately. Such alkali-soluble polymers include novolac resin, resol resin, produced free-radical polymerized polymers comprising a phenolic hydroxyl group or a carboxyl group, polyimide precursors, polyimide and polybenzoxazole precursors. Said polymers preferably have an alkali-soluble group in their molecules.

Said alkali-soluble group may be, for instance, a carboxyl group, phenolic hydroxyl group, sulfonic group or thiol group.

Said novolac resin and resol resin may be produced through condensation polymerization of one or more phenols with a known method using an aldehyde such as formalin.

Said phenols used to produce novolac resin or resol resin include, but not limited to, phenol, p-cresol, m-cresol, o-cresol, 2,3-dimethylphenol, 2,4-dimethylphenol, 2,5-dimethylphenol, 2,6-dimethylphenol, 3,4-dimethylphenol, 3,5-dimethylphenol, 2,3,4-trimethylphenol, 2,3,5-trimethylphenol, 3,4,5-trimethylphenol, 2,4,5-trimethylphenol, methylenebisphenol, methylene bis-p-cresol, resorcin, catechol, 2-methylresorcin, 4-methylresorcin, o-chlorophenol, m-chlorophenol, p-chlorophenol, 2,3-dichlorophenol, m-methoxyphenol, p-methoxyphenol, p-butoxyphenol, o-ethylphenol, m-ethylphenol, p-ethylphenol, 2,3-diethylphenol, 2,5-diethylphenol, p-isopropylphenol, α-naphthol, and β-naphthol, which may be used alone or in combination as a mixture.

Said aldehydes include formalin, paraformaldehyde, acetaldehyde, benzaldehydes, hydroxybenzaldehyde and chloroacetaldehyde, which may be used alone or in combination as a mixture.

For the invention, suitable homopolymers produced from free-radical polymerizable monomers comprising a phenolic hydroxyl group or a carboxyl group and/or copolymers produced through copolymerization of said free-radical polymerizable monomers with other free-radical polymerizable monomers can be produced with a known polymerization method using a free-radical polymerization innitiator.

Said free-radical polymerizable monomers comprising a phenolic hydroxyl group or a carboxyl group include, for instance, o-hydroxystyrene, m-hydroxystyrene, p-hydroxystyrene, and their alkyl-, alkoxy-, halogen-, haloalkyl-, nitro-, cyano-, amide-, ester-, or carboxy-substituted products; polyhydroxyvinylphenols such as vinyl hydroquinone, 5-vinyl pyrogallol, 6-vinyl pyrogallol, and 1-vinyl phloroglucinol; o-vinyl benzoic acid, m-vinyl benzoic acid, p-vinyl benzoic acid, and their alkyl-, alkoxy-, halogen-, nitro-, cyano-, amide-, or ester-substituted products; methacrylic acid, acrylic acid, and their alpha haloalkyl-, alkoxy-, halogen-, nitro-, or cyano-substituted products; bivalent unsaturated carboxylic acids such as maleic acid, maleic anhydride, fumaric acid, fumaric anhydride, citraconic acid, mesaconic acid, itaconic acid, 1,4-cyclohexene dicarboxylic acid, and their methyl, ethyl, propyl, i-propyl, n-butyl, sec-butyl, tert-butyl, phenyl, o-, m- or p-toluyl half esters and half amides. Of these, o-hydroxystyrene, m-hydroxystyrene, p-hydroxystyrene, and their alkyl- or alkoxy-substituted products are preferred because of their good properties in terms of sensitivity during patterning, resolution, remained film thickness after development, resistance to heat deformation, resistance to solvents, adhesion with substrates, and preservation stability of solutions. These may be used alone or in combination.

Other preferred free-radical polymerizable monomers include styrene and its substitution products with alkyl, alkoxy, halogen, haloalkyl, nitro, cyano, amide, or ester at α-, o-, m- or p-position; diolefins such as butadiene, isoprene, and chloroprene; methacrylate or acrylate esterified with methyl, ethyl, n-propyl, i-propyl, n-butyl, sec-butyl, tert-butyl, pentyl, neopentyl, isoamylhexyl, cyclohexyl, adamanthyl, allyl, propargyl, phenyl, naphthyl, anthracenyl, anthraquinonyl, piperonyl, salicyl, cyclohexyl, benzyl, phenethyl, cresyl, glycidyl, 1,1,1-trifluoroethyl, perfluoroethyl, perfluoro-n-propyl, perfluoro-i-propyl, triphenylmethyl, tricycle[5.2.1.0^{2,6}]decane-8-yl (generally referred to as dicyclopentanyl in the technical field of the invention), cumyl, 3-(N,N-dimethylamino)propyl, 3-(N,N-dimethylamino)ethyl, furil, or furfuryl; anilide or amide of methacrylic acid or acrylic acid, or N,N-dimethyl, N,N-diethyl, N,N-dipropyl, N,N-diisopropyl, anthranilamido, acrylonitrile, acrolein, methacrylonitrile, vinyl chloride, vinylidene chloride, vinyl fluoride, vinylidene fluoride, N-vinylpyrrolidone, vinylpyridine, vinyl acetate, N-phenyl maleimide, N-(4-hydroxyphenyl)maleinimide, N-methacryloylphthalimide, and N-acryloylphthalimide, which may be used alone or in combination. Of these, styrene and its substitution products with alkyl, alkoxy, halogen, or haloalkyl at α-, o-, m- or p-position; butadiene and isoprene; methacrylate or acrylate esterified with methyl, ethyl, n-propyl, n-butyl, glycidyl, or tricycle[5.2.1.0^{2,6}]decane-8-yl are preferred because of their good properties in terms of sensitivity during patterning, resolution, remained film thickness after development, resistance to heat deformation, resistance to solvents, adhesion with substrates, and preservation stability of solutions. If a copolymer produced from a free-radical polymerizable monomer that has the phenolic hydroxyl group with another free-radical polymerizable monomer is used as said alkali-soluble resin, the ratio of said another free-radical polymerizable monomer to the total amount of said free-radical polymerizable monomer that has the phenolic hydroxyl group and said another free-radical polymerizable monomer is preferably 30 percent by weight or less, more preferably 5-20 percent by weight. If a copolymer produced from a free-radical polymerizable monomer that has the carboxyl group with another free-radical polymerizable monomer is used as said alkali-soluble resin, the ratio of said another free-radical polymerizable monomer to the total amount of said free-radical polymerizable monomer that has the carboxyl group and said another free-radical polymerizable monomer is preferably 90wt% or less, more preferably 10-80wt%. Development with an alkali will be difficult in some cases if the ratio of these free-radical polymerizable monomers relative to the free-radical polymerizable monomer with the phenolic hydroxyl group or carboxyl group is larger than said ranges.

Preferred polymers for the invention that comprises a structural unit as shown by general formula (1) as main component can form a polymer having an imide ring, oxazole ring or other rings under heating or a suitable catalyst. The main component should account for 50 mol% or more, preferably 70 mol% or more, still more preferably 90 mol% or more in terms of the amount of structural units. The formation of rings will act to drastically increase the heat resistance and solvent resistance. Thus, "heat-resistant resin" for the invention refers to a polymer that forms a ring structure under heating or a suitable catalyst or a polymer that comprises a ring.

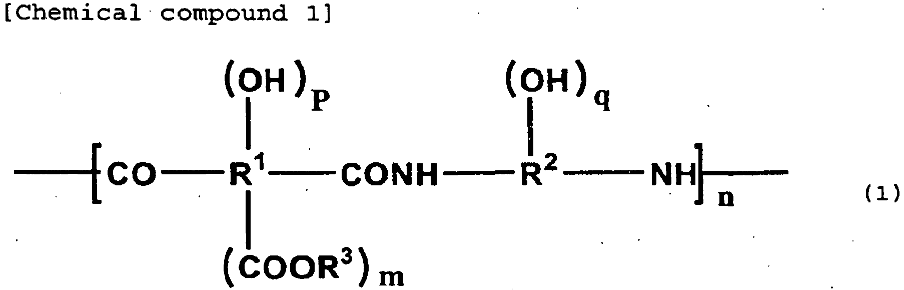

In the formula, R¹ denotes a bivalent to octavalent organic group with two or more carbon atoms, R² a bivalent to hexavalent organic group with two or more carbon atoms, and R³ a hydrogen atom or an organic group with 1-20 carbon atoms. And, n indicates an integer in the range of 10 to 100000, m an integer in the range of 0 to 2, and p and q an integer in the range of 0 to 4 that meet the following formula: p+q≥0.

General formula (1) given above represents a polyamic acid and/or polyamic acid ester having a hydroxyl group, and it is only natural that p+q>0 is preferred. With this hydroxyl group, said substance is more soluble in an alkaline solution than a polyamic acid that is free of the hydroxyl group. Phenolic hydroxyl groups, among others, are preferred in terms of the solubility in alkaline solutions. If each molecular of said polymer that comprises, as main component, a structural unit as shown by general formula (1) contains 10 wt% or more of fluorine atom, the film interface will have a moderate degree of repellency during development with an alkaline solution, serving to prevent the infiltration of the solution into the interface. A fluorine content above 20 wt% is undesirable since it will cause a decrease in the solubility in an alkaline solution, a decrease in the organic solvent resistance of said polymer in which a ring has been introduced by heating, and a decrease in the solubility in fuming nitric acid. Thus it is preferred that the fluorine content is in the range of 10 to 20 wt%.

In general formula (1) given above, R¹ represent a structural unit of an acid dianhydride, which is preferably a bivalent to octavalent organic group that comprises an aromatic ring, one to four hydroxyl groups, and two or more carbon atoms, more preferably a trivalent or quadrivalent organic group with 6-30 carbon atoms.

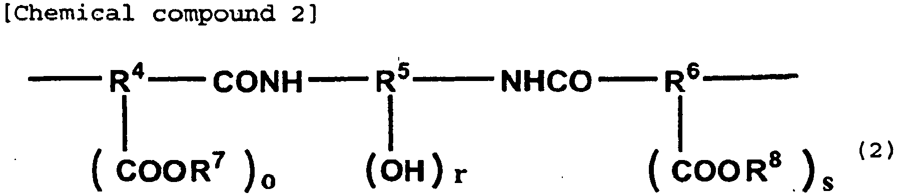

R⁴ and R⁶ represent a bivalent to quadrivalent organic group with 2-20 carbon atoms, R⁵ a trivalent to hexavalent organic group with a hydroxyl group and 3-20 carbon atoms, and R⁷ and R⁸ either a hydrogen or an organic group with 1-20 carbon atoms. In addition, o and s denote an integer in the range of 0 to 2, and r shows an integer in the range of 1 to 4.

Specifically, a structure as shown by general formula (2) where R⁴ and R⁶ represent a bivalent to quadrivalent organic group with 2-20 carbon atoms is preferred, and furthermore it preferably contains an aromatic ring to produce a highly heat-resistant polymer, with particularly preferred structures being trimellitic acid, trimesic acid, and naphtalenetricarboxylic acid residue. R⁵ is preferably a trivalent to hexavalent organic group with a hydroxyl group and 3-20 carbon atoms. Moreover, it is preferred that said hydroxyl group is located at a position next to the amide bond. Thus, preferred substances include bis(3-amino-4-hydroxyphenyl)hexafluoropropane and bis(3-hydroxy-4-aminophenyl)hexafluoropropane that contain a fluorine atom; and bis(3-amino-4-hydroxyphenyl)propane, bis(3-hydroxy-4-aminophenyl)propane, 3,3'-diamino-4,4'-dihydroxybiphenyl, 3,3'-diamino-4,4'-dihydroxybiphenyl, 2,4-diamino-phenol, 2,5-diamino-phenol, and 1,4'-diamino-2,5-dihydroxybenzene that have an amino group bonded and that contain no fluorine atoms.

Moreover, R⁷ and R⁸ in general formula (2) are preferably either a hydrogen atom and/or an organic group with 1-20 carbon atoms. Solubility in an alkali developer will decrease as the number of carbon atoms exceeds 20.

In general formula (2), o and s denote an integer in the range of 0 to 2, and r shows an integer in the range of 1 to 4. The characteristics of the heat resistant resin film obtained will deteriorate as r exceeds 5.

Specifically, preferred structural units as represented by general formula (2) include the following. But these are not intended to limit the invention.

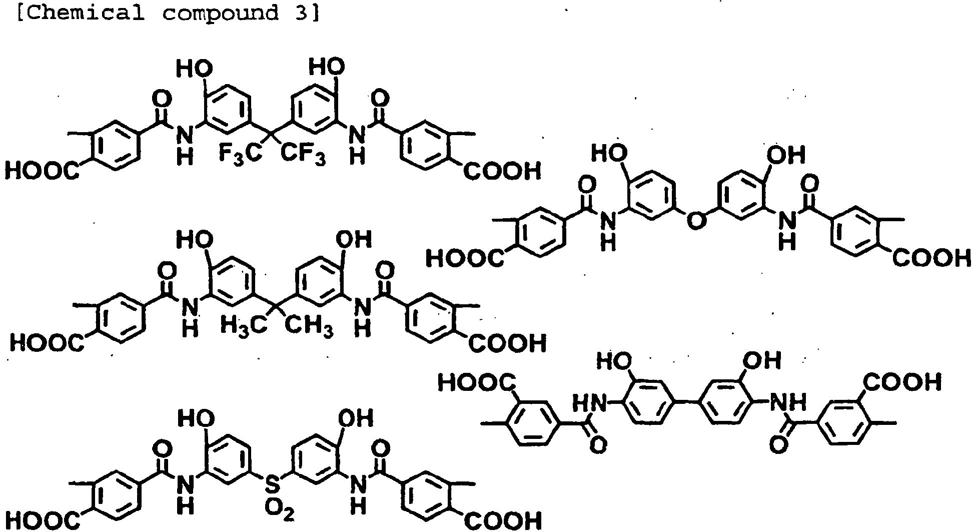

The compound may be denatured with a tetracarboxylic acid or a dicarboxylic acid that is free of the hydroxyl group unless the solubility in alkalis, photosensitivity or heat resistance is decreased. Such acids include aromatic tetracarboxylic acids such as pyromellitic acid, benzophenone tetracarboxylic acid, biphenyltetracarboxylic acid, diphenyl ether tetracarboxylic acid and diphenylsulfone tetracarboxylic acid; diester compounds produced by replacing their two carboxyl groups with methyl groups or ethyl groups; aliphatic tetracarboxylic acids such as butane tetracarboxylic acid and cyclopentane tetracarboxylic acid; diester compounds produced by replacing their two carboxyl groups with methyl groups or ethyl groups; aromatic dicarboxylic acids such as terephthalic acid, isophthalic acid, diphenyl ether dicarboxylic acid and naphthalene dicarboxylic acid; and aliphatic dicarboxylic acids such as adipicacid. Their proportion to the total acid component should be 50 mol% or less, preferably 30 mol% or less. The solubility in alkalis and photosensitivity may deteriorate as the proportion of said compounds used denaturation exceeds 50 mol%.

In general formula (1) given above, R² represents a diamine residue. R² should comprise a hydroxyl group and an aromatic ring so that the resulting polymer will have a high heat resistance. Specifically, preferred units include fluorine-containing bis(amino-hydroxy-phenyl)hexafluoropropane, fluorine-free diaminodihydroxypyrimidine, diaminodihydroxypyridine, hydroxy-diamino-pyrimidine, diaminophenol, dihydroxybenzidine, and other units that has a structure as represented by general formula (3), (4) or (5).

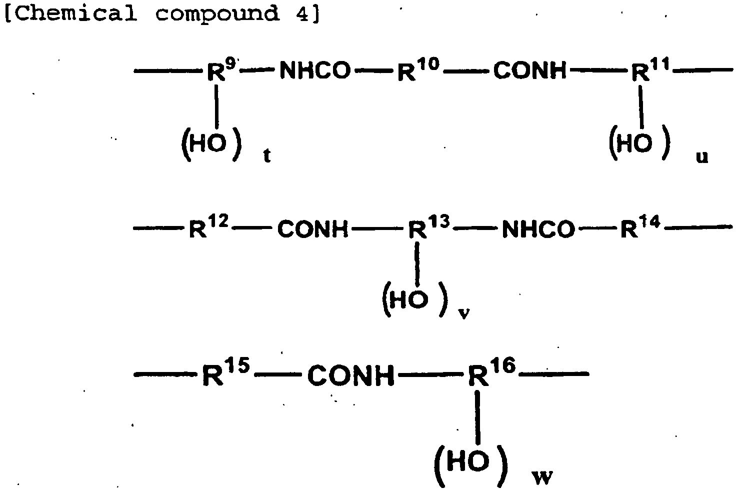

R⁹ and R¹¹ represent a trivalent to quadrivalent organic group that comprises a hydroxyl group and 2-20 carbon atoms, R¹⁰ a bivalent organic group comprising 2-30 carbon atoms, and t and u an integer of 1 or 2. R¹² and R¹⁴ represent a bivalent organic group that comprises 2-20 carbon atoms, R¹³ a trivalent to hexavalent organic group that comprises a hydroxyl group and 3-20 carbon atoms, and v an integer of 1-4. R¹⁵ represents a bivalent organic group that comprises 2-20 carbon atoms, R¹⁶ a trivalent to hexavalent organic group that comprises a hydroxyl group and 3-20 carbon atoms, and w an integer of 1-4.

Here, R⁹ and R¹¹ in general formula (3), R¹³ in general formula (4) and R¹⁶ in general formula (5) are preferably an organic group comprising an aromatic ring and a hydroxyl group so that the resulting polymer will have a high heat resistance. R¹⁰ in general formula (3), R¹² and R¹⁴ in general formula (4) and R¹⁵ in general formula (5) are preferably an organic group comprising an aromatic ring so that the resulting polymer will have a high heat resistance. Furthermore, t and u in general formula (3) represent an integer of 1 or 2, and v in general formula (4) and w in general formula (5) denote an integer of 1-4.

Specif ically, preferred structural units as represented by general formula (3) include the following.

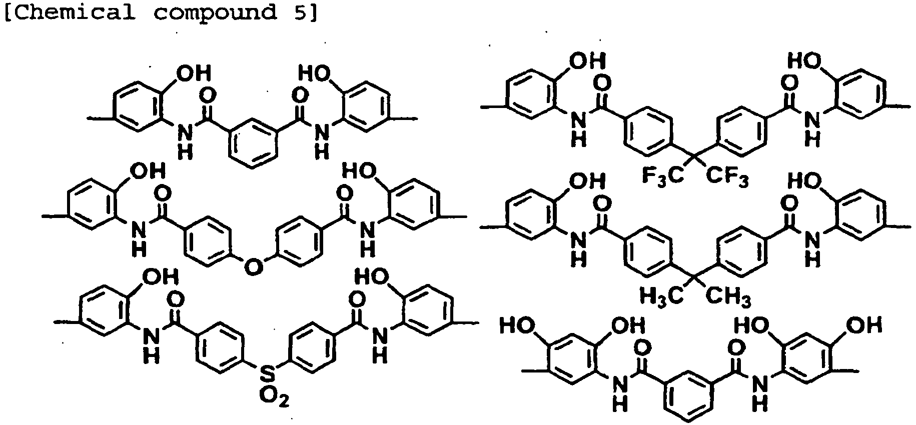

Preferred structural units as represented by general formula (4) include the following.

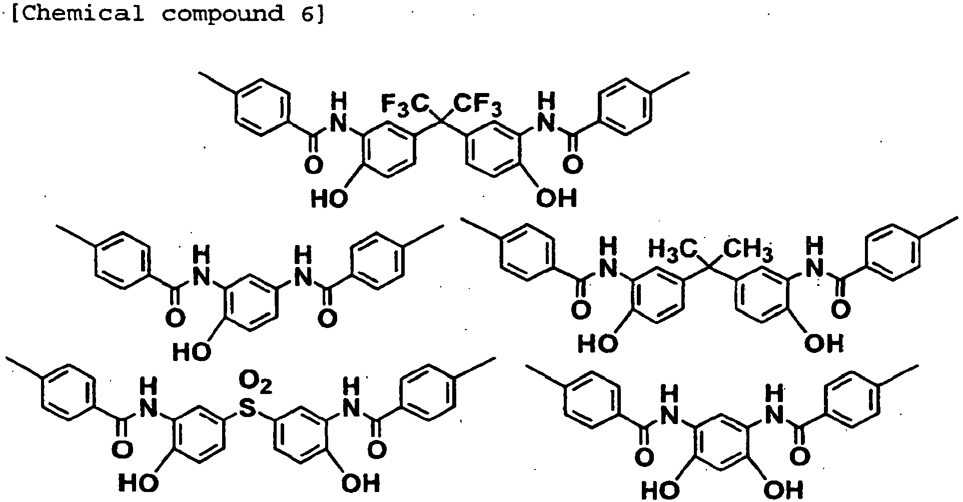

Preferred structural units as represented by general formula (5) include the following.

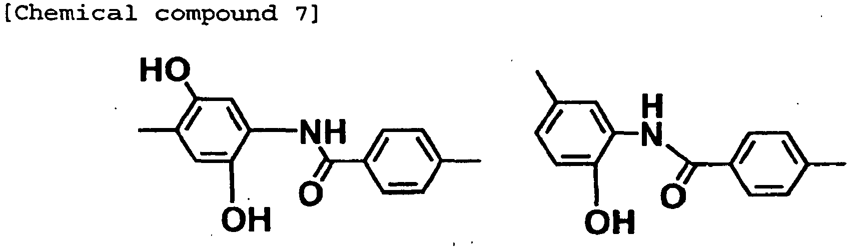

In a structure as given by general formula (3), R⁹ and R¹¹ represent a trivalent-quadrivalent organic group that comprises a hydroxyl group and 2-20 carbon atoms and preferably comprises an aromatic ring so that the resulting polymer will have a high heat resistance. Specifically, preferred groups include hydroxyphenyl, dihydroxyphenyl, hydroxynaphthyl, dihydroxynaphthyl, hydroxybiphenyl, dihydroxybiphenyl, bis(hydroxyphenyl)hexafluoropropane, bis(hydroxyphenyl)propane, bis(hydroxyphenyl)sulfone, hydroxydiphenyl ether, and dihydroxydiphenyl ether. Aliphatic goups such as hydroxycyclohexyl and hydroxycyclohexyl are also preferred. R¹⁰ represents a bivalent organic group comprising 2-30 carbon atoms. Bivalent groups comprising an aromatic ring are preferably used so that the resulting polymer will have a high heat resistance, and such groups include phenyl, biphenyl, diphenyl ether, diphenylhexafluoropropane, diphenylpropane and diphenylsulfone, as well as aliphatic cyclohexyl.

In a structure as given by general formula (4), R¹² and R¹⁴ represent a bivalent organic group comprising 2-20 carbon atoms. Bivalent groups comprising an aromatic ring are preferably used so that the resulting polymer will have a high heat resistance, and such groups include phenyl, biphenyl, diphenyl ether, diphenylhexafluoropropane, diphenylpropane and diphenylsulfone, as well as aliphatic cyclohexyl. R¹³ represents a trivalent-hexavalent organic group comprising a hydroxyl group and 3-20 carbon atoms, and preferably comprises an aromatic ring so that the resulting polymer will have a high heat resistance. Specifically, preferred groups include hydroxyphenyl, dihydroxyphenyl, hydroxynaphthyl, dihydroxynaphthyl, hydroxybiphenyl, dihydroxybiphenyl, bis(hydroxyphenyl)hexafluoropropane, bis(hydroxyphenyl)propane, bis(hydroxyphenyl)sulfone, hydroxydiphenyl ether, and dihydroxydiphenyl ether. Aliphatic goups such as hydroxycyclohexyl and dihydroxycyclohexyl are also preferred.

In a structure as given by general formula (5), R¹⁵ represents a bivalent organic group comprising 2-20 carbon atoms. Bivalent groups comprising an aromatic ring are preferably used so that the resulting polymer will have a high heat resistance, and such groups include phenyl, biphenyl, diphenyl ether, diphenylhexafluoropropane, diphenylpropane and diphenylsulfone, as well as aliphatic cyclohexyl. R¹⁶ represents a trivalent-hexavalent organic group comprising a hydroxyl group and 3-20 carbon atoms, and preferably comprises an aromatic ring so that the resulting polymer will have a high heat resistance. Specifically, preferred groups include hydroxyphenyl, dihydroxyphenyl, hydroxynaphthyl, dihydroxynaphthyl, hydroxybiphenyl, dihydroxybiphenyl',
bis(hydroxyphenyl) hexafluoropropane, bis (hydroxyphenyl) propane, bis(hydroxyphenyl)sulfone, hydroxydiphenyl ether, and dihydroxydiphenyl ether. Aliphatic goups such as hydroxycyclohexyl and dihydroxycyclohexyl are also preferred.

These structures may be denatured with other diamine components in the range of 1-40 mol%. Such substances include phenylenediamine, diaminodiphenyl ether, aminophenoxybenzene, diaminodiphenylmethane, diaminodiphenylsulfone, bis(trifluoromethyl)benzidine, bis(aminophenoxyphenyl)propane, bis(aminophenoxyphenyl)sulfone, and compounds produced by substituting an alkyl group or a halogen atom in the aromatic ring of the preceding compounds, as well as aliphatic cyclohexyldiamine and methylene biscyclohexylamine. The heat resistance of the resulting polymer will deteriorate if these diamine components are used for copolymerization up to more than 40 mol%.

In general formula (1), R³ represents either a hydrogen atom or an organic group comprising 1-20 carbon atoms. R³ is preferably an organic group to provide a stable positive photosensitive resin composition solution, while it is preferably a hydrogen atom to achieve a high solubility in alkali solutions. For the present invention, a hydrogen atom and an alkyl group may coexist. The amount of the hydrogen atom and the organic group used as R³ affects the rate of dissolution inalkali solutions, so a positive photosensitive resin composition with a preferred rate of dissolution can be produced by controlling the amount. It is preferred that the hydrogen atom accounts for 10%-90% of the R³ units. Said compounds will be insoluble in alkali solutions as the number of carbon atoms in R³ exceeds 20. Thus, it is preferred that R³ comprises one or more hydrocarbon atom with 1-16 carbon atoms, with the rest being hydrogen atoms.

In general formula (1), m, which represents the number of carboxyl groups, is an integer of 0-2, while n in general formula (1), which denotes the number of repeating units in the polymer of the invention, is preferably in the range of 10-100000.

Polyhydroxyamide, which has a similar structure to polyamic acid, can be used as heat-resistant polymer precursor instead of polyamic acid. In such a polyhydroxyamide production method, a bisaminophenol compound may be condensed with dicarboxylic acid. Specifically, a dehydration agent such as dicyclohexylcarbodiimide (DCC) may be reacted with an acid, followed by addition of a bisaminophenol compound, or a tertiary amine such as pyridine is added to a solutionof abisaminophenol compound, followed by dropping of a solution of dicarboxylic acid dichloride.

If polyhydroxyamide is used, addition of a photosensitizing agent such as naphthoquinonediazidosulfonate to the polyhydroxyamide solution will serve to produce a positive photosensitive resin composition wherein portions exposed to ultraviolet light can be removed with an alkaline solution.

To enhance the adhesion with the substrate, an aliphatic group with a siloxane structure may be introduced, through copolymerization with a substance having said siloxane structure for instance, in the R¹ or R² components in general formula (1) to the extent that it will not decrease the heat resistance. Specifically, copolymerization may be performed with a 1-10 mol% diamine component such as bis (3-aminopropyl) tetramethyldisiloxane and bis(p-amino-phenyl)octamethylpentasiloxane.
Said polymer of the invention as represented by general formula (1) may comprise only its structural unit, but also may be a copolymerization or blending product with other structural units. Insuchcases, it is preferred that the structural units as represented by general formula (1) account for 90 mol% or more of the polymer. Suitable structural units should be added for copolymerization or blending to the extent that they will not act to decrease the heat resistance of the polyimide-based polymer resulting from final heating.

Said polymer of the invention as represented by general formula (1) may be produced by, for instance, reacting tetracarboxylic dianhydride with a diamine compound at a low temperature, reacting tetracarboxylic dianhydride with an alcohol to produce a diester which is then reacted with an amine under the existence of a condensing agent, or reacting tetracarboxylic dianhydride with an alcohol to produce a diester and subsequently converting the remaining dicarboxylic acid into an acid chloride, followed by reaction with an amine.

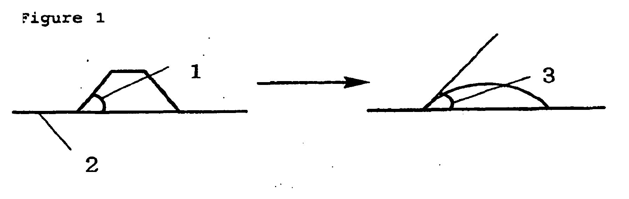

Compound (b) used for the invention is an important component of the composition which contains particles to lower the flowability during heat processing, serving to achieve an accurate lens shape regardless of the flowability during heat processing. If the flowability is low during heat processing, it will be difficult to produce an accurate lens shape by using the surface tension, so compound (b) is introduced to first produce a pattern as shown in Figure 1 that allows the pattern shape after exposure and development to have taper angle 1 of 65° or less, followed by heat-melting the composition by heat processing at a temperature in the range of 130 to 400°C, preferably 170 to 400°C to provide patterned heat-resistant resin film in a lens shape with taper angle 3 of 55° or less.

A pattern shown in Figure 1 is produced by the use of compound (b) which absorbs ultraviolet light used for exposure, but is not bleached by the light. So, compound (b) should have absorption capacity in the ultraviolet light range. Since compound (b) absorbs ultraviolet light emitted from exposure equipment, a large portion of the light used for exposure will be absorbed when a photosensitive resin composition is patterned by light exposure, but the compound, which is not bleached by the light, will act as a light-absorbing agent, leading to a large difference in the proportion of sensitized photosensitizing agent molecules between the top and the bottom of the film, namely leading to a difference in the rate of development between the top and the bottom of the film, to ensure easy formation of the tapered pattern as mentioned above.

A preferred compound as compound (b) of the invention absorbs at least one selected from the group of the i-line (365 nm), h-line (405 nm) and g-line (436 nm) which are generally used for exposure, but is not decomposed or bleached by rays with said wavelengths. Light sources are widely available, and therefore, compounds with light absorption capacity at these wavelengths are preferred. As a matter of course, this does not mean that the compound should not have light absorption capacity at other wavelengths. Since the invention is mainly applied to optical devices, transparency at wavelengths of 400 to 700 nm should be maintained after heat processing in the range of 130 to 400°C, preferably 170 to 400°C. Therefore, absorption at wavelengths of 400 to 700 nm originating in said compound should not increase if said compound is vaporized, lost or decomposed during heat processing. If the absorption at wavelengths of 400 to 700 nm of said compound increases, film may be colored by heat processing, resulting in material that is not suitable for optical uses.

Compound (b) of the invention should accounts for 2-30 parts by weight, preferably 2-25 parts by weight, relative to 100 parts by weight of the polymer. Thus, the minimum content is 2 parts by weight, while the maximum is 30 parts by weight, preferably 25 parts by weight. A content of less than 2 part by weight will allow the taper angle in the pattern shape produced by development to be above 65°, while a content of more than 30 parts by weight will lead to a large decarese in sensitivity during the patterning process causing some practical troubles.

To allow the taper angle 1 in the pattern shape produced by development to be 65° or less, the positive photosensitive resin composition of the invention should have an appropriate transmittance measured per 1.2 µm of thickness after coating and drying for rays with wavelengths of 365-436 nm, particularly at 365 nm, and preferably the wavelengths of the rays used for exposure. To meet these requirements, said transmittance is preferably in the range of 20-70%, particularly preferably 30-70%, depending on the type of compound (b). A transmittance of less than 20% will lead to a large decarese in sensitivity during the patterning process causing some practical troubles. If it is more than 70%, on the other hand, the taper angle in the pattern shape can exceed 65°, and a proper lens shape in some cases will fail to be produced by said heat processing in the range of 130 to 400°C, preferably 170 to 400°C. To ensure a proper transmittance as described above, it is important for the content of compound (b) to be in said range.

Compounds that meet these characteristics of compound (b) include coumarin derivatives, benzotriazole derivatives and hydroxybenzophenone derivatives. Preferred coumarin derivatives include Coumarin and Coumarin-4 (products of Sigma-Aldrich Japan K.K.), and 4-Hydroxycoumarin and 7-Hydroxycoumarin (products of Tokyo Chemical Industry Co., Ltd.). Preferred benzotriazole derivatives include Sumisorb 200, Sumisorb 250, Sumisorb 320, Sumisorb 340 and Sumisorb 350 (products of Sumitomo Chemical Co., Ltd.). Preferred hydroxybenzophenone derivatives include Sumisorb 130 and Sumisorb 140 (products of Sumitomo Chemical Co., Ltd.), Zislizer M and Zislizer O (products of Sankyo Kasei Co., Ltd.), and Seesorb 103(product of Shipro Kasei Kaisha, Ltd.). Of these, a compound that can be removed by heat processing at a temperature in the range of 130 to 400°C, preferably 170 to 400°C, should be used, or if it is not removed, it should degrade with its absorption capacity in the range of 400 to 700 nm not increased as compared to that before the heat processing. For compound (b) to be removed, its molecular weight should preferably be in the range of 100-350.

Preferred compounds to be used as compound (b) include Coumarin, Coumarin-4, 4-Hydroxycoumarin, 7-Hydroxycoumarin, Sumisorb 130, Sumisorb 200, Zislizer M and Zislizer O. The structural formulae of preferred compounds are described below.

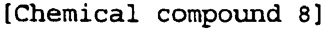

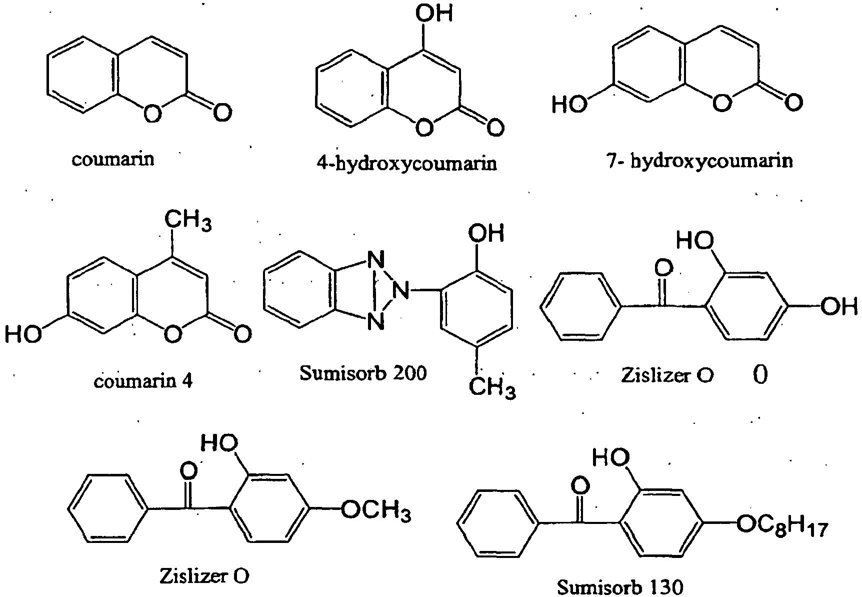

Preferred quinone diazide compounds as compound (c) of the invention consist of a compound with a phenolic hydroxyl group connected with naphthoquinone diazide sulfonic acid through an ester. Preferred compounds with a phenolic hydroxyl group to be used here include Bis-Z, BisOC-Z, BisOPP-Z, BisP-CP, Bis26X-Z, BisOTBP-Z, BisOCHP-Z, BisOCR-CP, BisP-MZ, BisP-EZ, Bis26X-CP, BisP-PZ, BisP-IPZ, BisCR-IPZ, BisOCP-IPZ, BisOIPP-CP, Bis26X-IPZ, BisOTBP-CP, TekP-4HBPA(tetrakis P-DO-BPA), TrisP-HAP, TrisP-PA, BisOFP-Z, BisRS-2P, BisPG-26X, BisRS-3P, BisOC-OCHP, BisPC-OCHP, Bis25X-OCHP, Bis26X-OCHP, BisOCHP-OC, Bis236T-OCHP, Methylenetris-FR-CR, BisRS-26X and BisRS-OCHP (products of Honshu Chemical Industry Co., Ltd.), BIR-OC, BIP-PC, BIR-PC, BIR-PTBP, BIR-PCHP, BIP-BIOC-F, 4PC, BIR-BIPC-F and TEP-BIP-A (products of Asahi Organic Chemicals Industry Co., Ltd.), 4,4'-Sulphonyldiphenol (product of Wako Pure Chemical Industries, Ltd.), and BPFL (product of JFE Chemical Corporation).

Of these, preferred compounds with a phenolic hydroxyl group include Bis-Z, BisP-EZ, TekP-4HBPA, TrisP-HAP, TrisP-PA, BisOCHP-Z, BisP-MZ, BisP-PZ, BisP-IPZ, BisOCP-IPZ, BisP-CP, BisRS-2P, BisRS-3P, BisP-OCHP, methylenetris-FR-CR, BisRS-26X, BIP-PC, BIR-PC, BIR-PTBPandBIR-BIPC-F. Of these, particularly preferred compounds with a phenolic hydroxyl group include Bis-Z, TekP-4HBPA, TrisP-HAP, TrisP-PA, BisRS-2P, BisRS-3P, BIR-PC, BIR-PTBP, BIR-BIPC-F, 4,4'-sulphonyldiphenol and BPFL. Preferred compounds can be produced by introducing 4-naphthoquinone diazide sulfonic acid or 5-naphthoquinone diazide sulfonic acid into one of these compounds with a phenolic hydroxyl group through an ester bond, though other compounds may also be used. The content of said quinone diazide compound (c) should be 1-50 parts by weight relative to 100 parts by weight of said polymer with an alkali-soluble group.

If a naphthoquinone diazide compound with a molecular weight of larger than 1000 is used for the invention, such a naphthoquinone diazide compound will not be decomposed sufficiently during the subsequent heat processing, probably resulting film with some problems such as a decreased heat resistance, poor mechanical properties and poor adhesion capability. From this viewpoint, said naphthoquinone diazide compound should have a molecular weight of 300 to 1000, preferably 350 to 800. The amount of said naphthoquinone diazide compound should be 1 to 50 parts by weight relative to 100 parts by weight of said polymer with an alkali-soluble group.

A compound with a phenolic hydroxyl group as listed above may be added with the aim of decreasing the rate of dissolution of unexposed portions during development.

Preferred Compounds with a phenolic hydroxyl group include Bis-Z, BisP-EZ, TekP-4HBPA, TrisP-HAP, TrisP-PA, BisOCHP-Z, BisP-MZ, BisP-PZ, BisP-IPZ, BisOCP-IPZ, BisP-CP, BisRS-2P, BisRS-3P, BisP-OCHP, methylenetris-FR-CR, BisRS-26X, BIP-PC, BIR-PC, BIR-PTBP and BIR-BIPC-F. Of these, particularly preferred compounds with a phenolic hydroxyl group include Bis-Z, TekP-4HBPA, TrisP-HAP, TrisP-PA, BisRS-2P, BisRS-3P, BIR-PC, BIR-PTBP, BIR-BIPC-F, 4,4'-sulphonyldiphenol and BPFL, though other compounds may also be used.

The content of said compound with a phenolic hydroxyl group is preferably more than 0 and less than 100 parts by weight, particularly preferably more than 0 and less than 30 parts by weight, relative to 100 parts by weight of said polymer with an alkali-soluble group. A content of more than 0 and less than 100 parts by weight relative to 100 parts by weight of the polymer will allow said compound with a phenolic hydroxyl group to act to increase the solubility in alkalis of the photosensitive resin composition, leading to an increase in the solubility of exposed portions during development. A content of 100 parts by weight or more relative to 100 parts by weight of the polymer will lead to an unnecessarily high solubility in alkalis of the photosensitive resin composition, making patterning difficult to perform.

Component (d) of the invention is inorganic particles of at least one or more materials selected from the group of aluminum compounds, silicon compounds, tin compounds, titanium compounds and zirconium compounds with a diameter of 1 to 30 nm. Specifically, they include aluminum complexes, aluminium oxide particles, tin oxide-aluminium oxide composite particles, silicon oxide-aluminium oxide composite particles, zirconium oxide-aluminium oxide composite particles, tin oxide-silicon oxide composite particles, zirconium oxide-silicon oxide composite particles, tin complexes, tin oxide particles, zirconium oxide-tin oxide composite particles, titanium complexes, titanium oxide particles, tin oxide-titanium oxide composite particles, silicon oxide-titanium oxide composite particles, zirconium oxide-titanium oxide composite particles, zirconium complexes and zirconium oxide particles. Preferred ones include tin oxide-titanium oxide composite particles, silicon oxide-titanium oxide composite particles, titanium oxide particles, zirconium oxide-tin oxide composite particles, zirconium oxide-silicon oxide composite particles and zirconium oxide particles.

The number average particle diameter of said inorganic particles as measured with laser diffraction and scattering is preferably 1 to 30 nm, particularly preferably 1 to 15 nm. A particle diameter of 1 to 30 nm makes it possible to achieve a photosensitivity that allows a desired resolvable pattern to be produced by light exposure of said composition. If the particle diameter is more than 30 nm, the resulting composition will not have a sufficient photosensitivity because it causes irregular reflection of rays used for light exposure, failing to produce a desired resolvable pattern. The content of these inorganic particles should be 5 to 500 parts by weight, preferably 50 to 500 parts by weight, particularly preferably 60 to 300 parts by weight, relative to 100 parts by weight of the polymer. Thus, the minimum content is 5 parts by weight, preferably 50 parts by weight, more preferably 60 parts by weight, relative to 100 parts by weight of the polymer, while the maximum content is 500 parts by weight, preferably 300 parts by weight. It can be seen that a content of 5 to 500 parts by weight, preferably 50 to 500 parts by weight, relative to 100 parts by weight of the polymer, acts to increase both the refractive index and transmittance (particularly at 400 nm) . A content of less than 5 parts by weight can lead to an insufficient transparency and refractive index, while a content of more than 500 parts by weight can make it very difficult to perform patterning to achieve any photosensitivity though both the transparency and refractive index can be increased.

These inorganic particle materials can be used alone or for composite particles. In addition, these inorganic particle materials can be used in combination as a mixture.

Commercially available compounds include "OptorakeTR-502" and "OptorakeTR-504" tin oxide-titanium oxide composite particles, "OptorakeTR-503" silicon oxide-titanium oxide composite particles, "OptorakeTR-505", "OptorakeTR-512", "OptorakeTR-513", "OptorakeTR-514" and "OptorakeTR-515" titanium oxide particles (products of Catalysts & Chemicals Ind. Co., Ltd.), zirconium oxide particles (Kojundo Chemical Lab. Co., Ltd.), tin oxide-zirconium oxide composite particles (Catalysts & Chemicals Ind. Co., Ltd.) and tin oxide particles (Kojundo Chemical Lab. Co., Ltd.).

As required, surfactants, esters such as ethyl lactate and propylene glycol monomethyl ether acetate, alcohols such as ethyl alcohol, ketones such as cyclohexanone and methyl isobutyl ketone, ethers such as tetrahydrofuran and dioxane may be added to improve the wettability between said photosensitive resin composition and the substrate. Other inorganic particles or powder of polyimide etc. may also be added.

To improve the adhesion with a silicon wafer substrate, furthermore, a silane coupling agent etc. may be added to photosensitive resin composition varnish up to 0.5 to 10 wt%, or such a silicon wafer substrate may be pretreated with such chemicals.

Such agents for addition to varnish include aluminum chelating agents or silane coupling agents such as methylmethacryloxy dimethoxy silane and 3-aminopropyl trimethoxy silane, which may be added up to 0.5 to 10 wt% relative to the amount of the polymer in the varnish.

When treating a substrate, said coupling agents are dissolved in a solvent such as isopropanol, ethyl alcohol, methyl alcohol, water, tetrahydrofuran, propylene glycol monomethyl ether acetate, propylene glycol monomethyl ether, ethyl lactate and diethyl adipate up to 0.5 to 20 wt% to produce a solution, which is applied over the surface with such techniques as spin coating, immersion, spray coating and steam treatment. In some cases, the reaction between the substrate and the coupling agents may be enhanced by subsequent heating in the temperature range of 50 to 300°C.

Described below are methods to produce a resin pattern using the photosensitive resin composition of the invention.

First, the photosensitive resin composition is applied over the substrate. Materials often used for the substrate include, but not limited to, silicon wafer, ceramics and gallium arsenide. Useful coating methods include rotation coating using a spinner, spray coating and roll coating. The coating thickness is generally in the range of 0.1 to 150 µm after drying, depending on the coating technique used and solid content and viscosity of the composition.

Then, the substrate coated with the photosensitive resin composition is dried to provide film of photosensitive resin composition. Drying is preferably performed for one minute to several hours in the temperature range of 50 to 150°C using an oven, hot plate, infrared light, etc.

Subsequently, a chemical ray is applied for exposure to the photosensitive resin composition film from above through a mask with a desired pattern. Ultraviolet light, visible light, electron beam, X-ray, etc., can be used as the chemical ray for exposure, but for the present invention, the i-line (365 nm), h-line (405 nm) and g-line (436 nm) of a mercury lamp are preferred.

After exposure, the development process is carried out using a developing solution to form patterned photosensitive resin. Preferred developing solutions include aqueous tetramethylammonium solution, and other solutions of an alkaline compound such as diethyl alcohol amine, diethylaminoethyl alcohol, sodium hydroxide, potassium hydroxide, sodium carbonate, potassium carbonate, triethylamine, diethylamine, methylamine, dimethylamine, dimethylaminoethyl acetate, dimethylaminoethyl alcohol, dimethylaminoethylmethacrylate, cyclohexylamine, ethylenediamine and hexamethylenediamine. In some cases, such alkaline solutions may contain polar solvents including N-methyl-2-pyrrolidone, N,N-dimethyl formamide, N,N-dimethyl acetamide, dimethylsulfoxide, γ-butyrolactone and dimethylacrylamide, alcohols including methyl alcohol, ethyl alcohol and isopropanol, esters including ethyl lactate and propylene glycol monomethyl ether acetate, and ketones including cyclopentanone, cyclohexanone, isobutyl ketone and methyl isobutyl ketone, which may be added alone or in combination. Rinsing with water is performed after development. Again, alcohols including ethyl alcohol and isopropyl alcohol, and esters including ethyl lactate and propylene glycol monomethyl ether acetate may be added to the water used for rinsing. If a homopolymer or a copolymer produced from free-radical polymerizable monomers comprising a phenolic hydroxyl group or a carboxyl group, or a copolymer produced through copolymerization of said free-radical polymerizable monomers comprising a phenolic hydroxyl group or a carboxyl group with other free-radical polymerizable monomers, novolac resin or resol resin is used as component (a), ultraviolet light is applied to unexposed portions after development up to 100 to 4000 mJ/cm², followed by heating in the range of 170 to 300°C to provide heat resistant resin film with enhanced heat resistance. If a polymer mainly comprising a structural unit as represented by general formula (1) is used as component (a), ultraviolet light is also applied to unexposed portions after development up to 100 to 4000 mJ/cm², followed by heating in the range of 200 to 400°C to provide heat-resistant resin film. This ultraviolet light exposure before heatingphotodecomposes compound (c) remaining in the positive photosensitive resin composition of the invention to ensure that the heat-resistant resin film produced by subsequent heating has a transmittance of 80% or more per µm of film thickness necessary for optical material in the range of 400 to 700 nm. If ultraviolet light exposure is not performed, compound (c) remaining in the composition will show absorption particularly at 400 to 450 nm and the transmittance will be less than 80%, which is not preferable. If inorganic particles containing a titanium compound is used, it will be possible to decompose compound (c) by a smaller exposure to ultraviolet light, partly owing to photocalytic reaction, which is preferable.

Furthermore, it is not preferable that a compound that shows absorption at 400-700 nm after heating in the range of 130 to 400°C, preferably 170 to 400°C, is used as compound (b). Because it will fail to produce heat-resistant resin film that is preferable as optical material.

This heating for conversion to heat-resistant resin film should performed for 5 minutes to 5 hours by increasing the temperature stepwise at selected temperatures or increasing the temperature continuously over a selected temperature range. For instance, heating may be performed at 170°C, 200°C and 350°C for 30 minutes at each temperature, or the temperature is increased linearly from room temperature to 400°C over a 2-hour period. Of these techniques, the use of a hot plate in a nitrogen atmosphere at 130 to 400°C, preferably 170 to 400°C, for 5 to 15 minutes is preferred in view of the fact that the resulting material will be used in an optical device.

As described above, the photosensitive resin composition of the invention serves to form an accurate lens shape with a high refractive index, and therefore, will be used to produce interlayer film and microlenses with a high refractive index for optical devices. The polymer is converted to heat-resistant resin by heating. In a microlens that can put the characteristics of the invention to practical use, it is preferred, for instance, that dots of 1 to 10 µm are arranged grid-like at intervals of 0.1 to 1.0 µm. Specifically, it ispossible to produce a relief pattern of an accurate lens shape in which fine dots preferably having a taper angle of 55° or less are arranged regularly. The resin composition of the invention serves to achieve high transmittance, and it is preferred that each dot has a light transmittance at 400 nm being 80% or more per µm. A light transmittance of 80% or more serves to eliminate the problem of colored transmitted light, and the resulting material can be used in, for instance, solid-state image sensors without having adverse effect on the color balance when a color filter is used.

A solid-state image sensor converts an image into electronic data through calculation based on the intensity of signals from and the position of regularly arranged charge coupled devices. The invention allows said relief pattern and charge coupled devices to be arranged so that each dot of the former comes on the photosensitive surface of each charge coupled device to enhance the light collection by the devices. As a result, not only highly sensitive solid-state image sensor can be produced, but also a higher resolution can be achieved by using smaller charge coupled devices.

### [Examples]

The invention is explained in detail below by using examples, though these examples are not intended to limit the invention. Evaluation of the photosensitive resin compositions and other materials described in these examples was carried out by the following methods.

Production of photosensitive resin composition film Photosensitive resin composition film was produced by coating a 6-inch silicon wafer or a 6-inch glass substrate with a positive photosensitive resin composition (hereafter referred to as varnish) so that the thickness after pre-bake treatment will be 1.2 µm as measured with the thickness measuring method described below, followed by pre-bake treatment at 120°C for 3 minutes using a SCW-636 hot plate (product of Dainippon Screen Mfg. Co., Ltd.).

Measuring method for film thickness Lambda Ace STM-602 manufactured by Dainippon Screen Mfg. Co., Ltd. was used to measure the film thickness of the photosensitive resin composition film at a refractive index of 1.64.

### Calculation of transmittance of photosensitive resin composition

The 365 nm transmittance of the photosensitive resin composition film prepared above on the 6-inch glass substrate was measured with a MultiSpec-1500 spectrophotometer for ultraviolet and visible region (product of Shimadzu Corporation).

### Light exposure

A patterned reticle was set on an exposure machine (NSR-1755-i7A i-line stepper manufactured by Nikon Corporation), and i-line exposure was performed up to 300 mJ/cm² (intensitry at 365 nm) for the photosensitive resin composition film prepared above on the 6-inch silicon wafer or 6-inch glass substrate.

### Development

After exposure, MARK-7 development equipment (product of Tokyo Electron Ltd.) was used to spray 2.38% tetramethylammonium hydroxide solution over the positive photosensitive resin composition film produced over a 6-inch silicon wafer or a 6-inch glass substrate. The sprayng was performed at a rotation rate of 50 per minute for 10 seconds. Then, the equipment was kept still at a rotation rate of 0 per minute for 40 seconds, followed by rinsing with water at a rotation rate of 400 per minute and shake-off drying at a rotation rate of 3000 per minute for 10 seconds.

### Confirmation of photosensitivity

After exposure and development, 5 µm square holes in the positive photosensitive resin composition film produced over a 6-inch silicon wafer were observed visually with Lambda Ace STM-602, the same equipment used for film thickness measurement described above, to confirm photosensitivity.

### Measurement of taper angle inpatternedphotosensitive resin composition after development

After development, the 2 µm line and space pattern was selected from the patterns in the positive photosensitive resin composition film produced over a 6-inch silicon wafer, and a diamond cutter was used to cut the pattern, and the cross section was observed with S-4800 FE-SEM manufactured by Hitachi High-Technologies Corporation to determine the taper angle (which, needless to say, is defined as the angle between the substrate plane and the tangent to the curved surface of the resin pattern at the boundary point between the substrate plane and the resin in the cross section).

### Preparation of heat-resistant resin film

After the exposure and development performed above, the positive photosensitive resin composition film produced over a 6-inch silicon wafer or a 6-inch glass substrate was exposed to ultraviolet light over the entire wavelength range (major wavelengths 365 nm, 405 nm, 436 nm) for 3 minutes at an ultraviolet light intensity of 5 mW/cm² (365 nm equivalent) using an exposure meter (PLA501F Contact Aligner manufactured by Canon Inc.,) followed by heat treatment at an appropriate temperature for 5 minutes with a hot plate (PMC Digital Hot Plate 722A-1 manufacture by As One Corp.) to produce heat-resistant resin film. In all examples and comparative examples, the thickness of heat-resistant resin film samples was 1 µm.

### Measurement of taper angle of patternedheat-resistant resin film

The 2 µm line and space pattern was selected from the patterns in the heat-resistant resin film produced over a 6-inch silicon wafer, and a diamond cutter was used to cut the pattern, followed by observation of the cross section with S-4800 FE-SEM manufactured by Hitachi High-Technologies Corporation to determine the taper angle.

Measuring method for refraction index of heat-resistant resin film The refractive index (TE) normal to said heat-resistant resin film produced over a 6-inch glass substrate was measured with a MODEL2010 prism coupler (product of Metricon Corp.) under the conditions of a wavelength at room temperature (22°C) of 632.8 nm (using He-Ne laser light source), refractive index of the 6-inch glass substrate N=1.4696, and measured refractive index range of 1.46-1.86.

Calculation of transmittance of heat-resistant resin film The transmittance at 400 nm and 650 nm of said heat-resistant resin film produced over a 6-inch glass substrate was measured with a MultiSpec-1500 spectrophotometer for ultraviolet and visible region (product of Shimadzu Corporation).

### Synthesis example 1: synthesis of hydroxyl-containing acid anhydride (a)

Under a dry nitrogen flow, 18.3g (0.05 moles) of 2,2-bis (3-amino-4-hydroxylphenyl)hexafluoropropane (BAHF) and 34.2g (0.3 moles) of allyl glycidyl ether was dissolved in 100g of gamma butyrolactone and cooled to -15°C. Then, a solution of 22.1g (0.11 moles) of trimellitic anhydride chloride dissolved in 50g of gamma-butyrolactone was dropped with the temperature of the solution kept below 0°C. After dropping was finished, the substances were allowed to react at 0°C for 4 hours. The resulting solution was then condensed with a rotary evaporator, and added to 1 liter of toluene to produce acid anhydride (a).

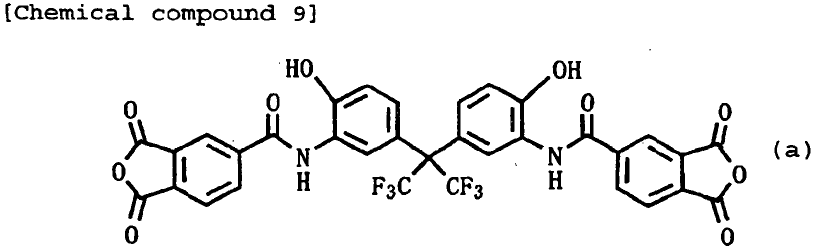

### Synthesis example 2: synthesis of hydroxyl-containing diamante compound (b)

To 100ml of acetone containing 17.4g (0.3moles) of propylene oxide, 18.3g (0.05 moles) of BAHF was dissolved, and cooled to -15°C. The a solution of 20.4g (0.11 moles) of 4-nitrobenzoyl chloride in 100ml of acetone was dropped. After the completion of dropping, the solution was allowed to react at -15°C for 4 hours , and then allowed to return to room temperature. The white solidprecipitate was separated by filtration, and dried in a vacuum at 50°C.

A 30g portion of the solidmaterial was put in a 300ml stainless steel autoclave, dispersed in 250ml of methyl cellosolve, followed by addition of 2g of 5% palladium carbon. Hydrogen was introduced using a balloon to ensure a reductive reaction at room temperature. In about 2 hours, the reaction was stopped after confirming that the balloon has stopped deflating. Following the completion of the reaction, the palladium compound used as catalyst was filtered out, and the solution was condensed with a rotary evaporator to produce diamine compound (b) . As-obtained solid was used for the subsequent reaction.

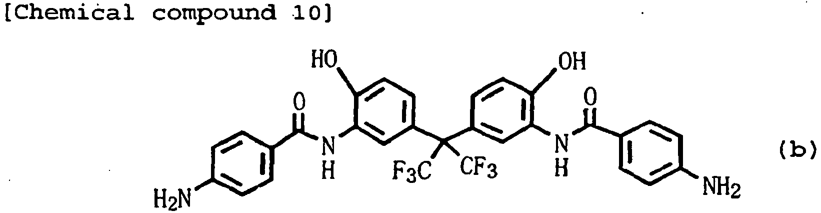

### Synthesis example 3: synthesis of hydroxyl-containing diamine (c)

To 50ml of acetone containing 30g (0.34 moles) of propylene oxide, 15.4g (0.1 moles) of 2-amino-4-nitrophenol was dissolved, and cooled to -15°C. Then, a solution produced by dissolving 11.2g (0.055 moles) of isophthalic chloride in 60ml of acetonwas dropped gradually. After the completion of dropping, the solution was allowed to react at -15°C for 4 hours. The solution was then allowed to return to room temperature, and the precipitate was collected by filtration.

The precipitate was dissolved in 200ml of gamma butyrolactone, and 3g of 5% palladium carbon was added, followed by strong stirring. A balloon containing hydrogen gas was fixed on the container, and stirring was continued at room temperature until the balloon has stopped deflating, followed by additional stirring for 2 hours with the hydrogen balloon fixed. After the completion of stirring, the palladium compound was filtered out, and the solution was condensed with a rotary evaporator until the volume decreased by 50%. Then, ethyl alcohol was added to cause recrystallization to produce crystals of the target compound.

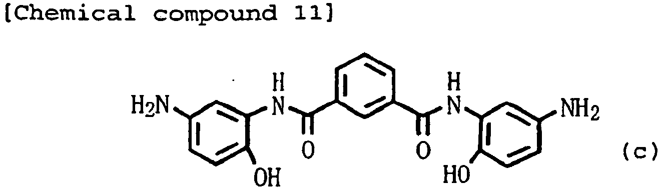

### Synthesis example 4: synthesis of hydroxyl-containing diamine (d)

To 100ml of acetone containing 17.4g (0.3 moles) of propylene oxide, 15.4g (0.1 moles) of 2-amino-4-nitrophenol was dissolved, and cooled to -15°C. Then, a solution produced by dissolving 20.4g (0.11 moles) of 4-nitrobenzoyl chloride in 100ml of aceton was dropped gradually. After the completion of dropping, the solution was allowed to react at -15°C for 4 hours. The solution was then allowed to return to room temperature, and the precipitate was collected by filtration. The same procedure as in Synthesis example 2 was carried out to produce crystals of the target compound.

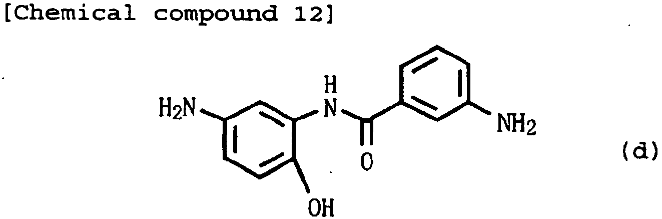

### Synthesis example 5: synthesis of quinone diazide compound (1)

Under a dry nitrogen flow, 7.21g (0.05 moles) of 2-naphthol and 13.43g (0.05 moles) of 5-naphthoquinone diazide sulfonyl chloride were dissolved in 450g of 1,4-dioxane, and kept at room temperature. Then, a mixture of 50g of 1,4-dioxane and 5.06g of triethylamine was dropped. After the completion of dropping, the solution was allowed to react at room temperature for 2 hours, and triethylamine salts were filtered out, followed by pouring the filtrate in water. Subsequently, the precipitate was collected by filtration. The precipitate was dried in a vacuum dryer to produce quinone diazide compound (1).

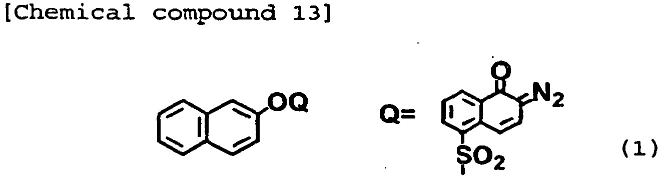

### Synthesis example 6: synthesis of quinone diazide compound (2)

Under a dry nitrogen flow, 15.31g (0. 05 moles) of TrisP-HAP (product of Honshu Chemical Industry Co., Ltd.) and 40.28g (0.15 moles) of 5-naphthoquinone diazide sulfonyl chloride were dissolved in 450g of 1,4-dioxane, and kept at room temperature. Using a mixture of 50g of 1,4-dioxane and 15.18g of triethylamine, the same procedure as in Synthesis example 5 was carried out to produce quinone diazide compound (2).

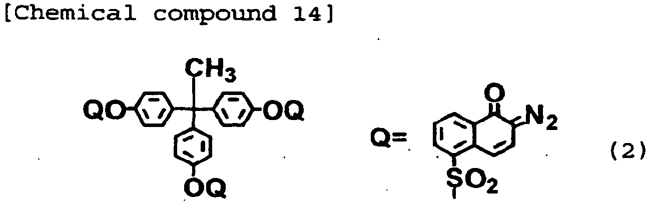

### Synthesis example 7: synthesis of quinone diazide compound (3)

Under a dry nitrogen flow, 6.81g (0.05 moles) of 4-isopropylphenol and 13.43g (0.05 moles) of 5-naphthoquinone diazide sulfonyl chloride were dissolved in 450g of 1,4-dioxane, and kept at room temperature. Then, using a mixture of 50g of 1,4-dioxane and 5.06g of triethylamine, the same procedure as in Synthesis example 5 was carried out to produce quinone diazide compound (3).

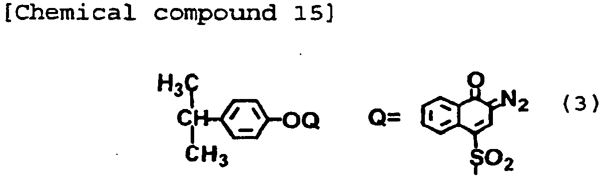

### Synthesis example 8: synthesis of quinone diazide compound (4)

Under a dry nitrogen flow, 11.41g (0.05 moles) of bisphenol A and 26.86g (0.1 moles) of 5-naphthoquinone diazide sulfonyl chloride were dissolved in 450g of 1,4-dioxane, and kept at room temperature. Then, usingamixtureof 50g of 1,4-dioxane and 10.12g of triethylamine, the same procedure as in Synthesis example 8 was carried out to produce quinone diazide compound (4).

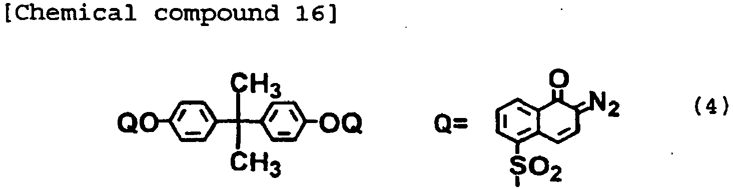

Listed below are some compounds that show absorption at the wavelengths of ultraviolet rays containing the i-line, h-line or g-line as bright line and compounds that contain the phenolic hydroxyl group used in the examples and comparative examples.

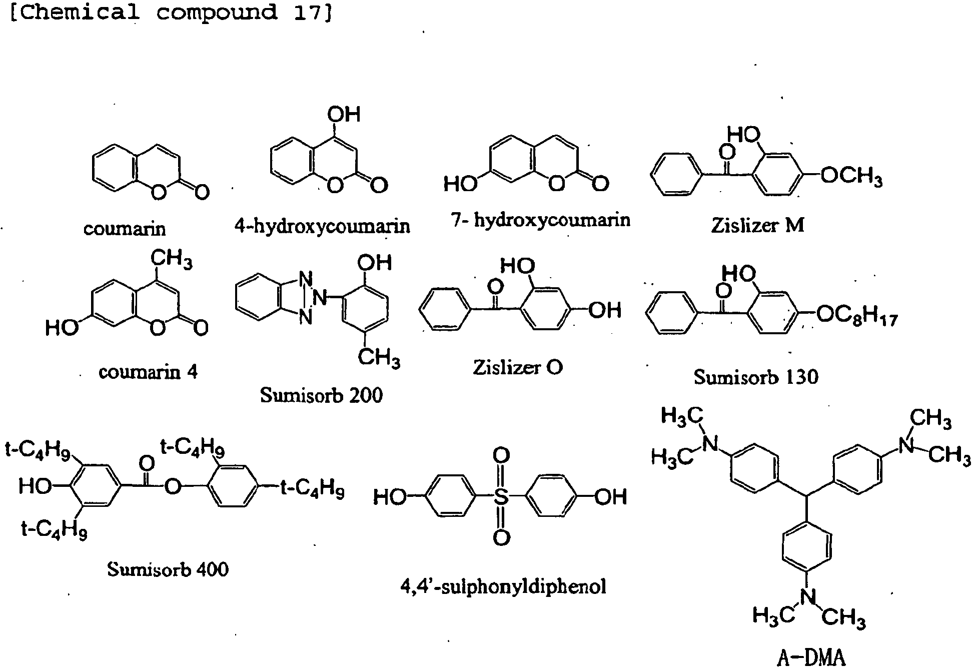

### Example 1

Under a nitrogen flow, 4.1g (0.0205 moles) of 4,4'-diaminodiphenyl ether and 1.24g (0.005 moles) of 1,3-bis (3-aminopropyl)tetramethyldisiloxane were dissolved in 50g of N-methyl-2-pyrrolidone (NMP). Then, a mixture of 21.4g (0.03 moles) of hydroxyl-containing acid anhydride (a) and 14g of NMP was added, and allowed to react at 20°C for 1 hour, followed by reaction at 50°C for 4 hours. Then, a solution produced by diluting 7.14g (0.06 moles) of N,N-dimethyl formamidedimethylacetal with 5g of NMP was dropped over a time period of 10 minutes . After completion of dropping, the solution was stirred at 50°C for 3 hours.

To 40g of the solution obtained, 2g of naphthoquinone diazide compound (1), 1. 6g of coumarin (product of Sigma-Aldrich Japan K. K.) and 50g of OptorakeTR-502 (product of Catalysts & Chemicals Ind. Co., Ltd., gamma butyrolactone solution, solid content 20%) with a particle diameter of 5 nm were added to produce a positive photosensitive resin composition, which is referred to as varnish A. The varnish obtained was then used to produce positive photosensitive resin film over a silicon wafer or a glass substrate, and subjected to light exposure, development and heating at 280°C, and evaluation was carried out to determine the photosensitivity of the varnish, transmittance of photosensitive resin composition film, transmittance of heat-resistant resin composition film and the taper angle.

### Example 2

Under a dry nitrogen flow, 13.6g (0.0225 moles) of diamine (b) produced in synthesis example 2 and 4-ethynylaniline (P-APAC, manufactured, used for terminal sealing, by Fuji Photo Film Co., Ltd.) were dissolved in 50g of N-methyl-2-pyrrolidone (NMP) . Then, a mixture of 17.5g (0.025 moles) of hydroxyl-containing acid anhydride (a) and 30g of pyridine were added and allowed to react at 60°C for 6 hours. After the completion of the reaction, the solution was poured in 2 liter of water, and precipitate of polymer solid was collected by filtration. The polymer solid was then dried at 80°C for 20 hours in a vacuum drier.

A 10g portion of the polymer solid thus obtained was weighed out and, along with 2g of naphthoquinone diazide compound (2) described above, 1g of vinyl trimethoxy silane, 0.5g of Zislizer O (product of Sankyo Kasei Co., Ltd.) and 50g of OptorakeTR-502 (product of Catalysts & Chemicals Ind. Co. , Ltd. , gamma butyrolactone solution, solid content 20%) with a particle diameter of 5 nm, were dissolved in 30g of gamma butyrolactone to produce a positive photosensitive resin composition, which is referred to as varnish B. The varnish obtained was then used to produce positive photosensitive resin film over a silicon wafer or a glass substrate, and subjected to light exposure, development and heating at 350°C, and evaluation was carried out to determine the photosensitivity of the varnish, transmittance of photosensitive resin composition film, transmittance of heat-resistant resin composition film and the taper angle.

### Example 3

Under a dry nitrogen flow, 20.78g (0.055 moles) of diamine compound (c) produced in synthesis example 3 and 1.24g (0.005 moles) of 1, 3-bis (3-aminopropyl)tetramethyldisiloxane were dissolved in 50g of NMP. Then, a mixture of 13.95g (0.045 moles) of 3,3',4,4' -diphenyl ether tetracarboxylic acid anhydrate and 21g of NMP was added and allowed to react at 20°C for 1 hour, followed by additional reaction at 50°C for 2 hours. After stirring at 50°C for 2 hours, a solution produced by diluting 14.7g (0.1 moles) of N,N-dimethyl formamidediethylacetal with 5g of NMP was dropped over a time period of 10 minutes. After the dropping, the solution was stirred at 50°C for 3 hours.

In 30g of the solutionobtained, 1.6g of naphthoquinone diazide compound (3) described above, 2.1g of Sumisorb 130 (product of Sumitomo Chemical Co., Ltd.) and 85g of OptorakeTR-505 (manufactured Catalysts & Chemicals Ind. Co., Ltd., gamma butyrolactone solution, solid content 20%) with a particle diameter of 10 nm were dissolved to produce a positive photosensitive resin composition which is referred to as varnish C. The varnish obtained was then used to produce positive photosensitive resin film over a silicon wafer or a glass substrate, and subjected to light exposure, development and heating at 300°C, and evaluation was carried out to determine the photosensitivity of the varnish, transmittance of photosensitive resin composition film, transmittance of heat-resistant resin composition film and the taper angle.

### Example 4

Under a dry nitrogen flow, 6.08g (0.025 moles) of diaminecompound (d) produced in synthesis example 4, 4.21g (0.021 moles) of 4,4'-diaminodiphenyl ether and 0.806g (0.00325 moles) of 1,3-bis (3-aminopropyl) tetramethyldisiloxane were dissolved in 70g of NMP. Then, 24.99g (0.035 moles) of hydroxyl-containing acid anhydrate (a), 4.41g (0.015 moles) of 3,3',4,4'-biphenyltetracarboxylic dianhydride and 25g of NMP were added at room temperature, followed by stirring at room temperature for 1 hour and at 50°C for 2 hours. Further, a solution produced by diluting 17.6g (0.2 moles) of glycidyl methyl ether with 10g of NMP was added and stirred at 70°C for 6 hours.

In 40g of this polymer solution, 2.5g of naphthoquinone diazide compound (4) described above, 1.6g of Sumisorb 200 (product of Sumitomo Chemical Co., Ltd.) and 150g of OptorakeTR-503 (manufactured Catalysts & Chemicals Ind. Co., Ltd., gamma butyrolactone solution, solid content 20%) with a particle diameter of 8 nm were dissolved to produce a positive photosensitive resin composition which is referred to as varnish D. The varnish obtained was then used to produce positive photosensitive resin film over a silicon wafer or a glass substrate, and subjected to light exposure, development and heating at 400°C, and evaluation was carried out to determine the photosensitivity of the varnish, transmittance of photosensitive resin composition film, transmittance of heat-resistant resin composition film and the taper angle.

### Example 5

Under a dry nitrogen flow, 16.93g (0.04625 moles) of 2,2-bis (3-amino-4-hydroxylphenyl)hexafluoropropane was dissolved in 50g of N-methyl-2-pyrrolidone (NMP) and 26.4g (0.3 moles) of glycidyl methyl ether, and the solution was cooled to -15°C. A solutionproduced by dissolving 7.38g (0.025 moles) of diphenyl ether dicarboxylic acid dichloride and 5.08g (0.025 moles) of isophthalic dichloride in 25g of gamma butyrolactone was dropped while keeping the temperature of the solution below 0°C. After the completion of dropping, stirring was continued at -15°C for 6 hours. After the completion of the reaction, the solution was poured in 3 liter of water, and white precipitate was collected. The precipitate collected by filtration was rinsed with water three times, and dried in a vacuum drier at 80°C for 20 hours.

A 10g portion of the polymer powder thus obtained, 2g of naphthoquinone diazide compound (2) described above, 1g of 4,4'-sulphonyldiphenol (products of Wako Pure Chemical Industries, Ltd.), 2g of coumarin (product of Sigma-Aldrich Japan K.K) and 100g of OptorakeTR-504 (products of Catalysts & Chemicals Ind. Co., Ltd., gamma butyrolactone solution, solid content 20%) with a particle diameter of 5 nm were dissolved in 30g of NMP to produce a positive photosensitive resin composition, which is referred to as varnish E. The varnish obtained was then used to produce positive photosensitive resin film over a silicon wafer or a glass substrate, and subjected to light exposure, development and heating at 320°C, and evaluation was carried out to determine the photosensitivity of the varnish, transmittance of photosensitive resin composition film, transmittance of heat-resistant resin composition film and the taper angle.

### Example 6

Under a dry nitrogen flow, 13.6g (0.0225moles) of diamine (b) produced in synthesis example 2 and 0.44g (0.0025 moles) of 4-(3-aminophenyl)-2-methyl-3-butyn-2-ol (M-APACB, product of Fuji Photo Film Co., Ltd.), used for terminal sealing, were dissolved in 50g of N-methyl-2-pyrrolidone (NMP). Then, a mixture of 17.5g (0.025 moles) of hydroxyl-containing acid anhydride (a) and 30g of pyridine were added and allowed to react at 60°C for 6 hours. After the completion of the reaction, the solution was poured in 2 liter of water, and precipitate of polymer solid was collected by filtration. The polymer solid was then dried at 80°C for 20 hours in a vacuum drier.

A 10g portion of the polymer solid thus obtained was weighed out and, along with 2g of naphthoquinone diazide compound (2) described above, 1g of vinyl trimethoxy silane, 2.5g of coumarin-4 (product of Sigma-Aldrich Japan K.K.) and 100.0g of OptorakeTR-504 (product of Catalysts & Chemicals Ind. Co., Ltd., gamma butyrolactone solution, solid content 20%) with a particle diameter of 5 nm, were dissolved in 30g of gamma butyrolactone to produce a positive photosensitive resin composition, which is referred to as varnish F. The varnish obtained was then used to produce positive photosensitive resin film over a silicon wafer or a glass substrate, and subjected to light exposure, development and heating at 300°C, and evaluation was carried out to determine the photosensitivity of the varnish, transmittance of photosensitive resin composition film, transmittance of heat-resistant resin composition film and the taper angle.

### Example 7

The same procedure as in example 1 was carried out except that 46.7g of zirconium oxide particles (product of Kojundo Chemical Lab. Co., Ltd., solid content 100%) with a particle diameter 5 nm and 3g of coumarin-4 (product of Sigma-Aldrich Japan K.K.) were used instead of OptorakeTR-502 (products of Catalysts & Chemicals Ind. Co. , Ltd., gamma butyrolactone solution, solid content 20%) with a particle diameter 5 nm and 1.6g of coumarin (product of Sigma-Aldrich Japan K.K.), respectively, to produce a positive photosensitive resin composition, which is referred to as varnish G. The varnish obtained was then used to produce positive photosensitive resin film over a silicon wafer or a glass substrate, and subjected to light exposure, development and heating at 320°C, and evaluation was carried out to determine the photosensitivity of the varnish, transmittance of photosensitive resin composition film, transmittance of heat-resistant resin composition film and the taper angle.

### Example 8

The same procedure as in example 3 was carried out except that tin oxide-zirconium oxide composite particle sol (product of Catalysts & Chemicals Ind. Co., Ltd., gamma butyrolactone solution, solid content 8.5%) with a particle diameter of 25 nm was used instead of OptorakeTR-505 (product of Catalysts & Chemicals Ind. Co. , Ltd., gamma butyrolactone solution, solid content 20%) with a particle diameter 10 nm to produce a positive photosensitive resin composition, which is referred to as varnish H. The varnish obtained was then used to produce positive photosensitive resin film over a silicon wafer or a glass substrate, and subjected to light exposure, development and heating at 350°C, and evaluation was carried out to determine the photosensitivity of the varnish, transmittance of photosensitive resin composition film, transmittance of heat-resistant resin composition film and the taper angle.

### Example 9

The same procedure as in example 2 was carried out except that aluminium oxide-titanium oxide composite particles (solid content 100%) with a particle diameter of 15 nm and 1g of coumarin (product of Sigma-Aldrich Japan K.K.) were used instead of OptorakeTR-502 (products of Catalysts & Chemicals Ind. Co., Ltd., gamma butyrolactone solution, solid content 20%) with a particle diameter of 5 nm and 0.5g of Zislizer O (product of Sankyo Kasei Co. , Ltd.), respectively, to produce a positive photosensitive resin composition, which is referred to as varnish I. The varnish obtained was then used to produce positive photosensitive resin film over a silicon wafer or a glass substrate, and subjected to light exposure, development and heating at 280°C, and evaluation was carried out to determine the photosensitivity of the varnish, transmittance of photosensitive resin composition film, transmittance of heat-resistant resin composition film and the taper angle.

### Example 10

The same procedure as in example 5 was carried out except that 18.3g (0.05 moles), instead of 16.93g, of 2,2-bis (3-amino-4-hydroxylphenyl)hexafluoropropane was used, and that 100g of tin oxide particles (product of Kojundo Chemical Lab. Co., Ltd., gamma butyrolactone solution, solid content 12%) with a particle diameter of 10 nm and 1g of coumarin-4 (product of Sigma-Aldrich Japan K.K.) were used instead of OptorakeTR-504 (product of Catalysts & Chemicals Ind. Co., Ltd. , gamma butyrolactone solution, solid content 20%) with a particle diameter of 5 nm and 2g of coumarin (product of Sigma-Aldrich Japan K. K.), respectively, to produce a positive photosensitive resin composition, which is referred to as varnish J. The varnish obtained was then used to produce positive photosensitive resin film over a silicon wafer or a glass substrate, and subjected to light exposure, development and heating at 300°C, and evaluation was carried out to determine the photosensitivity of the varnish, transmittance of photosensitive resin composition film, transmittance of heat-resistant resin composition film and the taper angle.

### Example 11

Under a dry nitrogen flow, 57g (0.6 moles) of meta cresol, 38g (0.4 moles) of para cresol, 75.5g (formaldehyde 0.93 moles) of 37wt% formaldehyde solution, 0.63g (0.005 moles) of oxalate dehydrate and 264g of methyl isobutyl ketone were mixed to provide a reaction liquid, which was then immersed in an oil bath, and allowed to undergo condensation polymerization for 4 hours under reflux. Subsequently, the oil bath was heated for 3 hours, and the pressure in the flask was decreased down to 30-50mmHg to remove volatile components, followed by cooling the resin, which was dissolved in the solution, to room temperature to produce 85g of polymer solid which was alkali-soluble novolac resin.

A 10g portion of the novolac resin thus obtained was weighed out and, along with 2g of naphthoquinone diazide compound (2) described above, 1g of Sumisorb 130 (product of Sumitomo Chemical Co., Ltd.), 1g of vinyl trimethoxy silane, 1g of Sumisorb 140 (product of Sumitomo Chemical Co., Ltd.) and 50g of OptorakeTR-502 (product of Catalysts &Chemicals Ind. Co., Ltd. , gamma butyrolactone solution, solid content 20%) with a particle diameter of 5 nm, were dissolved in 30g of gamma butyrolactone to produce a positive photosensitive resin composition, which is referred to as varnish K. The varnish obtained was then used to produce positive photosensitive resin film over a silicon wafer or a glass substrate, and subjected to light exposure, development and heating at 220°C, and evaluation was carried out to determine the photosensitivity of the varnish, transmittance of photosensitive resin composition film, transmittance of heat-resistant resin composition film and the taper angle.

### Example 12

Under a dry nitrogen flow, 5g of 2,2'-azobis (2,4-dimethylvaleronitrile), 200g of propylene glycol monomethyl ether acetate, 25g of para-hydroxyl-α-methylstyrene, 40g of acrylic acid and 30g of tricyclo [5.2.1.0^{2,6}] decane-8-yl acrylate were mixed to prepare a solution, which was stirred at 70°C for 4 hours to ensure reaction. After the completion of the reaction, the alkali-soluble, free-radical polymerized polymer solution was poured in 1000g of hexane, and the precipitate of polymer solid was collected by filtration. The polymer solid was dried at 80°C in a vacuum drier.

A 10g portion of the polymer solid thus obtained was weighed out and, along with 2g of naphthoquinone diazide compound (1) described above, 1g of Sumisorb 200 (product of Sumitomo Chemical Co. , Ltd.) and 70g of OptorakeTR-505 (product of Catalysts & Chemicals Ind. Co., Ltd., gamma butyrolactone solution, solid content 20%) with a particle diameter of 10 nm, was added to produce a positive photosensitive resin composition, which is referred to as varnish L. The varnish obtained was then used to produce positive photosensitive resin film over a silicon wafer or a glass substrate, and subjected to light exposure, development and heating at 200°C, and evaluation was carried out to determine the photosensitivity of the varnish, transmittance of photosensitive resin composition film, transmittance of heat-resistant resin composition film and the taper angle.

### Example 13

Under a dry nitrogen flow, 3.42g (0.0225 moles) of 3,5-diaminobenzoic acid (product of Tokyo Chemical Industry Co., Ltd.) and 0.29g (0.0025 moles) of 4-ethynylaniline (P-APAC, product of Fuji Photo Film Co., Ltd.), used for terminal sealing, were dissolved in 50g of N-methyl-2-pyrrolidone (NMP). Then, 17.5g (0.025 moles) of hydroxyl-containing acid anhydride (a) and 30g of pyridine were added and reacted at 60°C for 6 hours. After the completion of the reaction, the solution was poured in 2 liter of water, and precipitate of polymer solid was collected by filtration. Then, the polymer solid was dried at 80°C for 20 hours in a vacuum drier.

A 10g portion of the polymer solid thus obtained was weighed out and, along with 2g of naphthoquinone diazide compound (2) described above, 1g of vinyl trimethoxy silane, 1g of coumarin-4 (product of Sigma-Aldrich Japan K.K.) and 50g of OptorakeTR-502 (product of Catalysts & Chemicals Ind. Co., Ltd. , gamma butyrolactone solution, solid content 20%) with a particle diameter of 5 nm, was dissolved in 30g of gamma butyrolactone to produce a positive photosensitive resin composition, which is referred to as varnish M. The varnish obtained was then used to produce positive photosensitive resin film over a silicon wafer or a glass substrate, and subjected to light exposure, development and heating at 320°C, and evaluation was carried out to determine the photosensitivity of the varnish, transmittance of photosensitive resin composition film, transmittance of heat-resistant resin composition film and the taper angle.

### Example 14

The same procedure as in example 12 was carried out except that 2g of A-DMA (product of Hodogaya Chemical Co. , Ltd.) was used instead of 1g of Sumisorb 200 (product of Sumitomo Chemical Co., Ltd.) to produce a positive photosensitive resin composition, which is referred to as varnish S. The varnish obtained was then used to produce positive photosensitive resin film over a silicon wafer or a glass substrate, and subjected to light exposure, development and heating at 200°C, and evaluation was carried out to determine the photosensitivity of the varnish, transmittance of photosensitive resin composition film, transmittance of heat-resistant resin composition film and the taper angle.

A good lens shape was obtained though the patter was somewhat colored.

### Example 15

The same procedure as in example 2 was carried out except that 0.2g, instead of 0.5g, of Zislizer O (product of Sankyo Kasei Co., Ltd.) was used to produce a positive photosensitive resin composition, which is referred to as varnish U. The varnish obtained was then used to produce positive photosensitive resin film over a silicon wafer or a glass substrate, and subjected to light exposure, development and heating at 200°C, and evaluation was carried out to determine the photosensitivity of the varnish, transmittance of photosensitive resin composition film, transmittance of heat-resistant resin composition film and the taper angle.

### Comparative example 1

The same procedure as in example 1 was carried out except that OptorakeTR-502 and coumarin were not used, to produce a positive photosensitive resin composition, which is referred to as varnish N. The varnish obtained was then used to produce positive photosensitive resin film over a silicon wafer or a glass substrate, and subjected to light exposure, development and heating at 280°C, and evaluation was carried out to determine the photosensitivity of the varnish, transmittance of photosensitive resin composition film, transmittance of heat-resistant resin composition film and the taper angle.

### Comparative example 2

The same procedure as in example 2 was carried out except that 0. 05g of coumarin (product of Sigma-Aldrich Japan K.K.) was used instead of 0.5g of Zislizer O (product of Sankyo Kasei Co. , Ltd.) to produce a positive photosensitive resin composition, which is referred to as varnish O. The varnish obtained was then used to produce positive photosensitive resin film over a silicon wafer or a glass substrate, and subjected to light exposure, development and heating at 350°C, and evaluation was carried out to determine the photosensitivity of the varnish, transmittance of photosensitive resin composition film, transmittance of heat-resistant resin composition film and the taper angle.

### Comparative example 3

The same procedure as in example 3 was carried out except that 5.1g of Zislizer O (product of Sankyo Kasei Co., Ltd.) was used instead of 2.1g of Sumisorb 130 (product of Sumitomo Chemical Co., Ltd.), to produce a positive photosensitive resin composition, which is referred to as varnish P. The varnish obtained was then used to produce positive photosensitive resin film over a silicon wafer or a glass substrate, and subjected to light exposure, development and heating at 300°C, and evaluation was carried out to determine the photosensitivity of the varnish, transmittance of photosensitive resin composition film, transmittance of heat-resistant resin composition film and the taper angle.

### Comparative example 4

The same procedure as in example 10 was carried out except that 1000g, instead of 100g, of tin oxide particles (product of Kojundo Chemical Lab. Co., Ltd., gamma butyrolactone solution, solid content 12%) was used, to produce a positive photosensitive resin composition, which is referred to as varnish Q. The varnish obtained was then used to produce positive photosensitive resin film over a silicon wafer or a glass substrate, and subjected to light exposure, development and heating at 300°C, and evaluation was carried out to determine the photosensitivity of the varnish, transmittance of photosensitive resin composition film, transmittance of heat-resistant resin composition film and the taper angle.

### Comparative example 5

The same procedure as in example 4 was carried out except that Sumisorb 200 (product of Sumitomo Chemical Co. , Ltd.) was not used, to produce a positive photosensitive resin composition, which is referred to as varnish R. The varnish obtained was then used to produce positive photosensitive resin film over a silicon wafer or a glass substrate, and subjected to light exposure, development and heating at 400°C, and evaluation was carried out to determine the photosensitivity of the varnish, transmittance of photosensitive resin composition film, transmittance of heat-resistant resin composition film and the taper angle.

### Comparative example 6

The same procedure as in example 13 was carried out except that 1g of coumarin-4 (product of Sigma-Aldrich Japan K.K.) was not used, to produce a positive photosensitive resin composition, which is referred to as varnish T. The varnish obtained was then used to produce positive photosensitive resin film over a silicon wafer or a glass substrate, and subjected to light exposure, development and heating at 320°C, and evaluation was carried out to determine the photosensitivity of the varnish,transmittance of photosensitive resin composition film, transmittance of heat-resistant resin composition film and the taper angle.

The components used in examples 1-15 and comparative examples 1-6 are listed in Tables 1 and 2, and results of evaluation are shown in Table 3.
[Table 1]
[Table 2]
[Table 3]

### [Industrial Applicability]

The positive photosensitive resin composition of the invention can serve to produce a lens shape with high transparency and high refractive index that is suitable to optical devices.

**Table 1-1**

| | varnish | (a) polymer | (b) compound absorbing exposure | | (c) quinone diazide compound | | (d) inorganic particles | | | |
|---|---|---|---|---|---|---|---|---|---|---|
| | | | compound free of absorption increase during heating at 130-400°C | amount (parts by weight) relative to 100 parts by weight of polymer | compound | amount (parts by weight) relative to 100 parts by weight of polymer | product name | type of inorganic particles | particle diameter (nm) | amount (parts by weight) relative to 100 parts by weight of polymer |
| Example 1 | A | polyimide pecursor | coumarin | 15 | compound (1) | 18 | OptorakeTR-502 | tin oxide -- titanium oxide composite particles | 5 | 90 |
| Example 2 | B | polyimide pecursor | Zislizer 0 | 5 | compound (2) | 20 | OptorakeTR-502 | tin oxide - titanium oxide composite particles | 5 | 100 |
| Example 3 | C | polyimide pecursor | Sumisorb 130 | 25 | compound (3) | 19 | OptorakeTR-505 | titanium oxide particles | 10 | 200 |
| Example 4 | D | polyimide pecursor | Sumisorb 200 | 15 | compound (4) | 24 | OptorakeTR-503 | silicon oxide - titanium oxide composite particles | 8 | 290 |
| Example 5 | E | polybenzoxazole pecursor | coumarin | 20 | compound (2) | 20 | OptorakeTR-504 | tin oxide - titanium oxide composite particles | 5 | 200 |
| Example 6 | F | polyimide pecursor | coumarin-4 | 25 | compound (2) | 20 | OptorakeTR-504 | tin oxide - titanium oxide composite particles | 5 | 200 |
| Example 7 | G | polymide pecursor | coumarin-4 | 28 | compound (1) | 18 | -- | zirconium oxide | 5 | 420 |
| Example 8 | H | polyimide pecursor | Sumisorb 130 | 25 | compound (3) | 19 | -- | tin oxide - zirconium oxide composite particles | 25 | 85 |
| Example 9 | I | polyimide pecursor | coumarin | 10 | compound (2) | 20 | -- | aluminum oxide - titanium oxide composite particles | 15 | 500 |
| Example 10 | J | polybenzoxazole pecursor | coumarin-4 | 10 | compound (2) | 20 | -- | tin oxide particles | 10 | 120 |

**Table 1-2**

| | varnish | (a) polymer | (b) compound absorbing exposure | | (c) quinone diazide compound | | (d) inorganic particles | | | |
|---|---|---|---|---|---|---|---|---|---|---|
| | | | compound free of absorption increase during heating at 130-400° C | amount (parts by weight) relative to 100 parts by weight of polymer | compound | amount (parts by weight) relative to 100 parts by weight of polymer | product name | type of inorganic particles | particle diameter (nm) | amount (parts by weight) relative to 100 parts by weight of polymer |
| Example 11 | K | novolac resin | Sumisorb 130 Sumisorb 140 | 20 | compound (2) | 20 | OptorakeTR-502 | tin oxide - titanium oxide composite particles | 5 | 100 |
| Example 12 | L | free-radical polymerized polymer | Sumisorb 200 | 10 | compound (1) | 20 | OptorakeTR-505 | titanium oxide particles | 10 | 140 |
| Example 13 | M | polyimide pecursor | coumarin -4 | 10 | compound (2) | 20 | OptorakeTR-502 | tin oxide - titanium oxide composite particles | 5 | 100 |

**Table 2**

| | varnish | (a) polymer | (b) compound absorbing exposure light | | | (c) quinone diazide compound | | (d) inorganic particles | | | |
|---|---|---|---|---|---|---|---|---|---|---|---|
| | | | compound free of absorption increase during heating at 130-400°C | compound suffering absorption increase during heating at 130-400°C | amount (parts by weight) relative to 100 parts by weight of polymer | compound | amount (parts. by weight) relative to 100 parts by weight of polymer | product name | type of inorganic particles | particle diameter (nm) | amount (parts by weight) relative to 100 parts by weight of polymer |
| Example 14 | S | free-radical polymerized polymer | -- | A-DMA | 20 | compound (1) | 20 | OptorakeTR-505 | titanium oxide particles | 10 | 140 |
| Example 15 | U | polyimide pecursor | Zislizer O | -- | 2 | compound (2) | 20 | OptorakeTR-502 | tim oxide - titanium oxide composite particles | 5 | 100 |
| Comparative example 1 | N | polyimide pecursor | -- | -- | -- | compound (1) | 18 | -- | -- | -- | -- |
| Comparative example 2 | O | polyimide pecursor | coumarin | -- | 0.5 | compound (2) | 20 | OptorakeTR-502 | tin oxide - titanium oxide composite particles | 5 | 100 |
| Comparative example 3 | P | polyimide pecursor | Zislizer 0 | -- | 61 | compound (3) | 19 | OptorakeTR-505 | titanium oxide particles | 10 | 200 |
| Comparative example 4 | Q | polybenzoxazo le pecursor | coumarin-4 | -- | 10 | compound (2) | 20 | -- | tin oxide particles | 10 | 1200 |
| Comparative example 5 | R | polyimide pecursor | -- | -- | -- | compound (4) | 24 | OptorakeTR-503 | silicon oxide - titanium oxide composite particles | 8 | 290 |
| Comparative example 6 | T | polyimide pecursor | -- | -- | -- | compound (2) | 20 | OptorakeTR-502 | tin oxide - titanium oxide composite particles | 5 | 100 |

**Table 3**

| | Evaaluation Results | | | | | | |
|---|---|---|---|---|---|---|---|
| | photosensitive resin composition | | | heat-resistant resin composition film | | | |
| | transmittance at 365nm (%) | photosensitivity | taper angle of developed pattern | transmittance at 400nm (%) | transmittance at 650nm (%) | taper angle of heat treated pattern | refractive index |
| Example 1 | 65% | + | 62° | 90% | 91% | 50° | 1.73 |
| Example 2 | 59% | + | 60° | 82% | 93% | 45° | 1.74 |
| Example 3 | 35% | + | 55° | 88% | 95% | 30° | 1.76 |
| Example 4 | 45% | + | 64° | 93% | 92% | 45° | 1.81 |
| Example 5 | 62% | + | 53° | 85% | 90% | 38° | 1.78 |
| Example 6 | 60% | + | 61° | 91% | 94% | 50° | 1.77 |
| Example 7 | 52% | + | 58° | 81% | 90% | 30° | 1.80 |
| Example 8 | 60% | + | 62° | 82% | 93% | 55° | 1.73 |
| Example 9 | 59% | + | 48° | 84% | 90% | 35° | 1.79 |
| Example 10 | 65% | + | 40° | 87% | 92% | 24° | 1.78 |
| Example 11 | 66% | + | 64° | 80% | 95% | 50° | 1.74 |
| Example 12 | 67% | + | 53° | 81% | 97% | 35° | 1.77 |
| Example 13 | 68% | + | 57° | 88% | 92% | 30° | 1.74 |
| Example 14 | 45% | + | 53° | 70% | 52% | 35° | 1.75 |
| Example 15 | 65% | + | 63° | 85% | 94% | 50° | 1.75 |
| Comparative example 1 | 67% | + | 85° | 88% | 95% | 78° | 1.61 |
| Comparative example 2 | 81% | + | 95° | 91% | 94% | 90° | 1.76 |
| Comparative example 3 | 10% | (scum found) | - | 92% | 96% | - | 1.78 |
| Comparative example 4 | 68% | (scum found) | - | 89% | 96% | - | 1.82 |
| Comparative example 5 | 81% | + | 84° | 88% | 90% | 80° | 1.80 |
| Comparative example 6 | 82% | + | 82° | 88% | 90% | 75° | 1.74 |

## Claims

1. A positive photosensitive resin composition comprising: (a) 100 parts by weight of a polymer that has an alkali-soluble group, (b) 2-30 parts by wight, relative to 100 parts by weight of polymer (a), of a compound that absorbs ultraviolet light used for exposure, but is not bleached by the light, (c) 1-50 parts by weight relative to 100 parts by weight of polymer (a) of a quinone diazide compound, and (d) 5-500 parts by weight relative to 100 parts by weight of polymer (a), of particles of at least one inorganic substance selected from the group of an aluminum compound, silicon compound, tin compound, titanium compound and zirconium compound with a diameter in the range of 1 nm to 30 nm.

2. A positive photosensitive resin composition according to either Claim 1 wherein compound (b) absorbs at least one selected from the group of the i-line (365 nm), h-line (405 nm) and g-line (436 nm).

3. A positive photosensitive resin composition according to either Claim 1 wherein component (a) is novolac resin and/or resol resin.

4. A positive photosensitive resin composition according to either Claim 1 wherein component (a) is a homopolymer produced from free-radical polymerizable monomers having a phenolic hydroxyl group or a carboxyl group, or a copolymer produced from said free-radical polymerizable monomers, or a copolymer produced through copolymerization of said free-radical polymerizable monomers having a phenolic hydroxyl group or a carboxyl group with other free-radical polymerizable monomers.

5. A positive photosensitive resin composition according to either Claim 1 wherein component (a) is a polymer that mainly comprises a structural unit as represented by general formula (1). 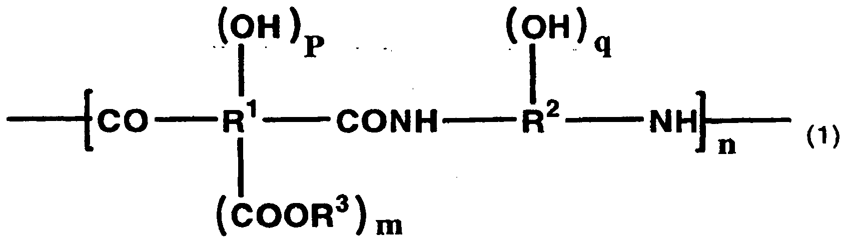 In the formula, R¹ denotes a bivalent to octavalent organic group with two or more carbon atoms, R² a bivalent to hexavalent organic group with two or more carbon atoms, and R³ a hydrogen atom or an organic group with 1-20 carbon atoms, n indicates an integer in the range of 10 to 100000, m an integer in the range of 0 to 2, and p and q an integer in the range of 0 to 4 that meet the following equation: p+q≥0.

6. A positive photosensitive resin composition according to Claim 5, wherein R¹ (COOR³)ₘ (OH)ₚ in general formula (1) is represented by general formula (2). 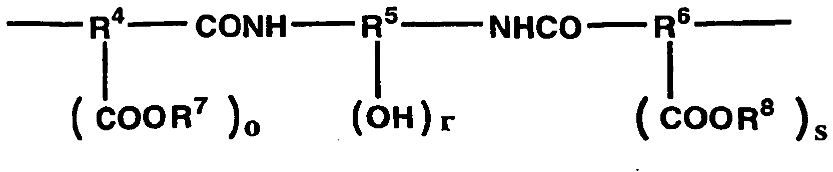 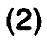 R⁴ and R⁶ represent a bivalent to quadrivalent organic group with 2-20 carbon atoms, R⁵ a trivalent to hexavalent organic group with 3-20 carbon atoms, and R⁷ and R⁸ either a hydrogen or an organic group with 1-20 carbon atoms. In addition, o and s denote an integer in the range of 0 to 2, and r shows an integer in the range of 1 to 4.

7. A positive photosensitive resin composition according to Claim 5, wherein R² (OH)_{q} in general formula (1) is at least one unit represented by any of general formulas (3)-(5). 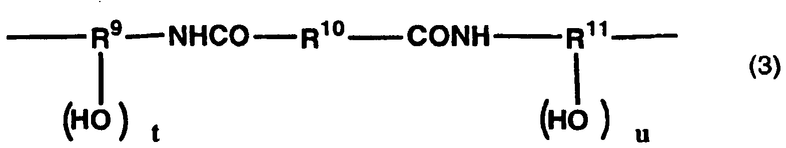 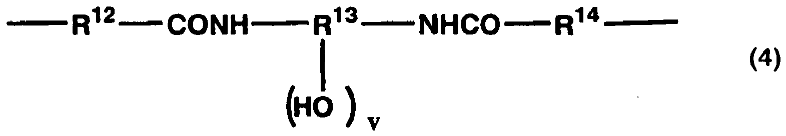 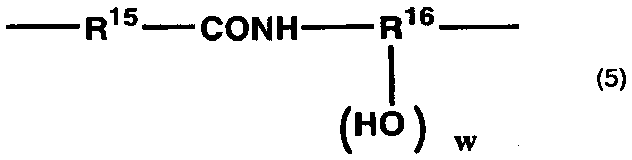 R⁹ and R¹¹ represent a trivalent to quadrivalent organic group that comprises 2-20 carbon atoms, R¹⁰ a bivalent organic group comprising 2-30 carbon atoms, and t and u an integer of 1 or 2. R¹² and R¹⁴ represent a bivalent organic group that comprises 2-20 carbon atoms, R¹³ a trivalent to hexavalent organic group that comprises 3-20 carbon atoms, and v an integer of 1-4. R¹⁵ represents a bivalent organic group that comprises 2-20 carbon atoms, R¹⁶ a trivalent to hexavalent organic group that comprises 3-20 carbon atoms, and w an integer of 1-4.

8. A positive photosensitive resin composition according to either Claim 1 wherein component (b) comprises one or more compounds selected from the group of coumarin derivatives, benzotriazole derivatives and hydroxylbenzophenone derivatives.

9. A positive photosensitive resin composition according to either Claim 1 wherein component (b) comprises a compound selected from the group consisting of Coumarin, Coumarin-4, 4-Hydroxycoumarin, 7-Hydroxycoumarin, Sumisorb 130, Sumisorb 200, Zislizer M and Zislizer O, whose structural formula are described below;

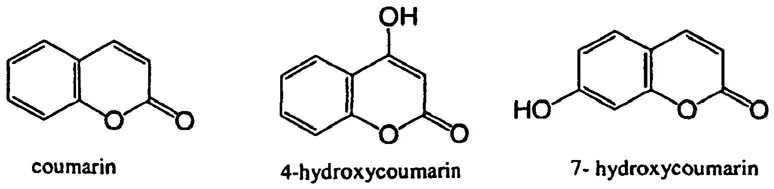

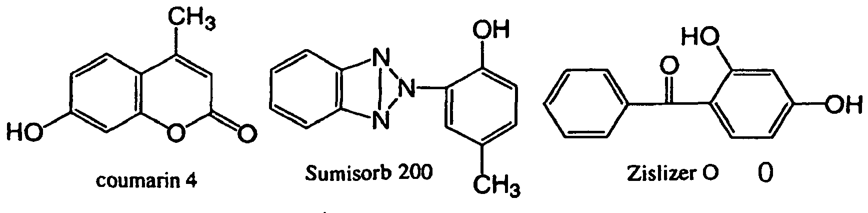

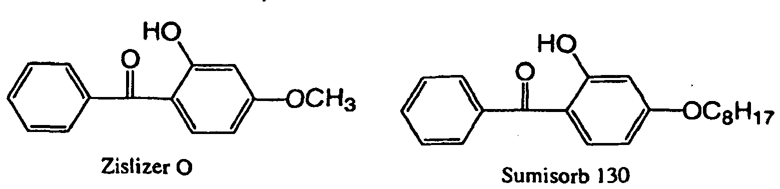

10. A relief pattern of heat resistant resin produced by exposing a positive photosensitive resin composition according to any of Claims 1-9 to ultraviolet light and subsequently heating it.

11. A solid-state image sensor produced from a relief pattern of heat resistant resin according to Claim 10.

## Patentansprüche

1. Positiv arbeitende lichtempfindliche Harzzusammensetzung, umfassend:
(a) 100 Gewichtsteile eines Polymers, das eine alkalilösliche Gruppe hat,
(b) 2 - 30 Gewichtsteile, bezogen auf 100 Gewichtsteile des Polymers (a), einer Verbindung, die ultraviolettes Licht, das zur Exposition verwendet wird, absorbiert, aber durch das Licht nicht gebleicht wird,
(c) 1 - 50 Gewichtsteile, bezogen auf 100 Gewichtsteile des Polymers (a), einer Quinondiazid-Verbindung, und
(d) 5 - 500 Gewichtsteile, bezogen auf 100 Gewichtsteile des Polymers (a), Partikel aus mindestens einer anorganischen Substanz, die aus der Gruppe ausgewählt ist, bestehend aus einer Aluminiumverbindung, Siliciumverbindung, Zinnverbindung, Titanverbindung und Zirconiumverbindung, wobei die Partikel einen Durchmesser in dem Bereich von 1 nm bis 30 nm haben.

2. Positiv arbeitende lichtempfindliche Harzzusammensetzung nach Anspruch 1, wobei die Verbindung (b) mindestens eine Linie absorbiert, die aus der Gruppe ausgewählt ist, bestehend aus der i-Linie (365 nm), h-Linie (405 nm) und g-Linie (436 nm).

3. Positiv arbeitende lichtempfindliche Harzzusammensetzung nach Anspruch 1, wobei der Bestandteil (a) ein Novolak-Harz und/oder Resol-Harz ist.

4. Positiv arbeitende lichtempfindliche Harzzusammensetzung nach Anspruch 1, wobei der Bestandteil (a) ein Homopolymer ist, das aus Monomeren hergestellt ist, die durch freie radikalische Polymerisation polymerisierbar sind, wobei die Monomere eine phenolische Hydroxylgruppe oder eine Carboxylgruppe haben, oder ein Copolymer ist, das aus den Monomeren hergestellt ist, die durch freie radikalische Polymerisation polymerisierbar sind, oder ein Copolymer ist, das durch Copolymerisation von den Monomeren, die durch freie radikalische Polymerisation polymerisierbar sind, wobei die Monomere eine phenolische Hydroxylgruppe oder eine Carboxylgruppe haben, und anderen Monomeren hergestellt ist, die durch freie radikalische Polymerisation polymerisierbar sind.

5. Positiv arbeitende lichtempfindliche Harzzusammensetzung nach Anspruch 1, wobei der Bestandteil (a) ein Polymer ist, das hauptsächlich eine Struktureinheit umfasst, wie sie durch die allgemeine Formel (1) repräsentiert ist. 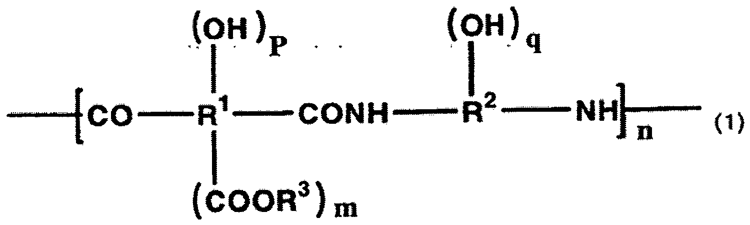 In der Formel bedeutet R¹ eine bivalente bis octavalente organische Gruppe mit zwei oder mehr Kohlenstoffatomen, R² eine bivalente bis hexavalente organische Gruppe mit zwei oder mehr Kohlenstoffatomen und R³ ein Wasserstoffatom oder eine organische Gruppe mit 1 - 20 Kohlenstoffatomen. In der Formel bezeichnet n eine ganze Zahl in dem Bereich von 10 bis 100000, m eine ganze Zahl in dem Bereich von 0 bis 2 und p und q eine ganze Zahl in dem Bereich von 0 bis 4, welche die folgende Gleichung erfüllt: p + q ≥ 0.

6. Positiv arbeitende lichtempfindliche Harzzusammensetzung nach Anspruch 5, wobei R¹(COOR³)ₘ(OH)ₚ in der allgemeinen Formel (1) durch die allgemeine Formel (2) repräsentiert wird. 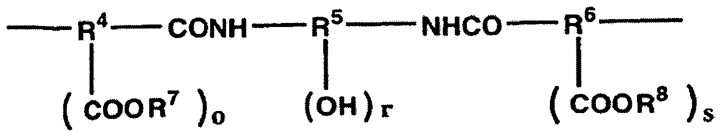 R⁴ und R⁶ repräsentieren eine bivalente bis quadrivalente organische Gruppe mit 2 - 20 Kohlenstoffatomen, R⁵ repräsentiert eine trivalente bis hexavalente organische Gruppe mit 3 - 20 Kohlenstoffatomen und R⁷ und R⁸ repräsentieren entweder Wasserstoff oder eine organische Gruppe mit 1 - 20 Kohlenstoffatomen. Zusätzlich bezeichnen o und s eine ganze Zahl in dem Bereich von 0 bis 2 und r stellt eine ganze Zahl in dem Bereich von 1 bis 4 dar.

7. Positiv arbeitende lichtempfindliche Harzzusammensetzung nach Anspruch 5, wobei R²(OH)_{q} in der allgemeinen Formel (1) mindestens eine Einheit ist, die durch irgendeine der allgemeinen Formeln (3) - (5) repräsentiert wird. 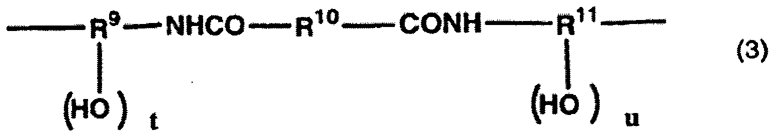 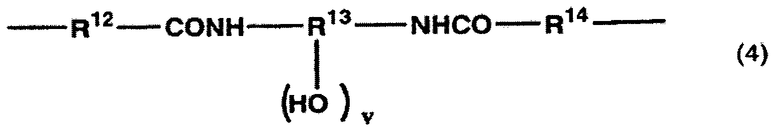 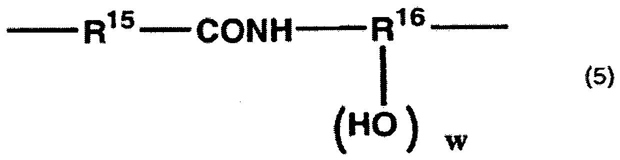 R⁹ und R¹¹ repräsentieren eine trivalente bis quadrivalente organische Gruppe, die 2-20 Kohlenstoffatome umfasst, R¹⁰ repräsentiert eine bivalente organische Gruppe, die 2 - 30 Kohlenstoffatome umfasst, und t und u repräsentieren eine ganze Zahl aus 1 oder 2. R¹² und R¹⁴ repräsentieren eine bivalente organische Gruppe, die 2 - 20 Kohlenstoffatome umfasst, R¹³ repräsentiert eine trivalente bis hexavalente organische Gruppe, die 3 - 20 Kohlenstoffatome umfasst, und v eine ganze Zahl von 1 - 4. R¹⁵ repräsentiert eine bivalente organische Gruppe, die 2 - 20 Kohlenstoffatome umfasst, R¹⁶ eine trivalente bis hexavalente organische Gruppe, die 3 - 20 Kohlenstoffatome umfasst, und w eine ganze Zahl von 1 - 4.

8. Positiv arbeitende lichtempfindliche Harzzusammensetzung nach Anspruch 1, wobei der Bestandteil (b) ein oder mehrere Verbindungen umfasst, die aus der Gruppe ausgewählt sind, bestehend aus Cumarin-Derivaten, Benzotriazol-Derivaten und Hydroxylbenzophenon-Derivaten.

9. Positiv arbeitende lichtempfindliche Harzzusammensetzung nach Anspruch 1, wobei der Bestandteil (b) eine Verbindung umfasst, die aus der Gruppe ausgewählt ist, bestehend aus Cumarin, Cumarin-4, 4-Hydroxycumarin, 7-Hydroxycumarin, Sumisorb 130, Sumisorb 200, Zislizer M und Zislizer O, deren Strukturformeln wie unten beschrieben sind;

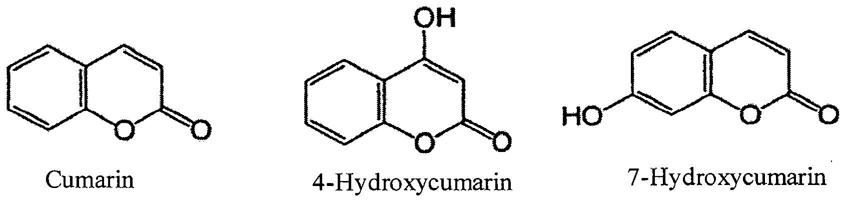

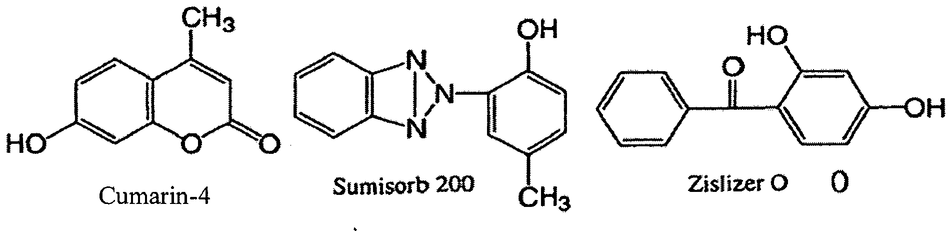

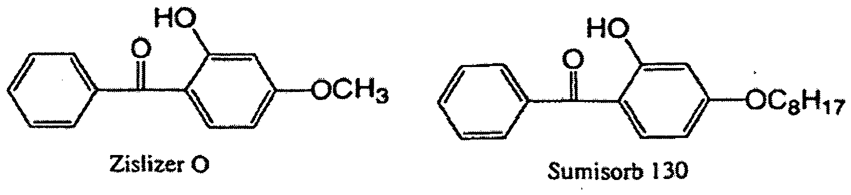

10. Reliefmuster aus hitzebeständigem Harz, welches hergestellt wird, indem eine positiv arbeitende lichtempfindliche Harzzusammensetzung nach einem der Ansprüche 1 - 9 ultraviolettem Licht ausgesetzt wird und anschließend erhitzt wird.

11. Festkörperbildsensor, hergestellt aus einem Reliefmuster aus einem hitzebeständigem Harz nach Anspruch 10.

## Revendications

1. Composition de résine photosensible positive comprenant : (a) 100 parties en poids d'un polymère qui comporte un groupe soluble dans un alcali, (b) de 2 à 30 parties en poids, par rapport à 100 parties en poids de polymère (a), d'un composé qui absorbe la lumière ultraviolette utilisée pour l'exposition, mais qui n'est pas blanchi par la lumière, (c) de 1 à 50 parties en poids, par rapport à 100 parties en poids de polymère (a), d'un composé diazide quinone, et (d) de 5 à 500 parties en poids, par rapport à 100 parties en poids de polymère (a), de particules d'au moins une substance inorganique choisie dans le groupe constitué d'un composé à base d'aluminium, d'un composé à base de silicium, d'un composé à base d'étain, d'un composé à base de titane et d'un composé à base de zirconium ayant un diamètre dans la plage de 1 nm à 30 nm.

2. Composition de résine photosensible positive selon la Revendication 1, dans laquelle le composé (b) absorbe au moins une raie choisie dans le groupe constitué de la raie i (365 nm), de la raie h (405 nm) et de la raie g (436 nm).

3. Composition de résine photosensible positive selon la Revendication 1, dans laquelle le composant (a) est une résine novolaque et/ou une résine résol.

4. Composition de résine photosensible positive selon la Revendication 1, dans laquelle le composant (a) est un homopolymère produit à partir de monomères à polymérisation radicalaire comportant un groupe hydroxyle phénolique ou un groupe carboxyle, ou un copolymère produit à partir desdits monomères à polymérisation radicalaire, ou un copolymère produit par copolymérisation desdits monomères à polymérisation radicalaire comportant un groupe hydroxyle phénolique ou un groupe carboxyle avec d'autres monomères à polymérisation radicalaire.

5. Composition de résine photosensible positive selon la Revendication 1, dans laquelle le composant (a) est un polymère qui comprend principalement un motif structural tel que représenté par la formule générale (1). 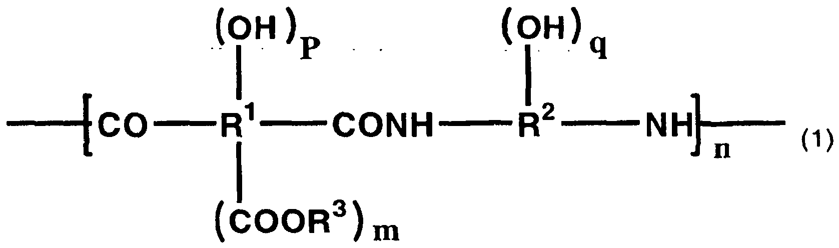 Dans la formule, R¹ désigne un groupe organique bivalent à octavalent comportant deux ou plusieurs atomes de carbone, R² un groupe organique bivalent à hexavalent comportant deux ou plusieurs atomes de carbone, et R³ un atome d'hydrogène ou un groupe organique comportant de 1 à 20 atomes de carbone, n indique un nombre entier dans la plage de 10 à 100 000, m un nombre entier dans la plage de 0 à 2, et p et q un nombre entier dans la plage de 0 à 4 qui satisfont l'équation suivante : p + q ≥ 0.

6. Composition de résine photosensible positive selon la Revendication 5, dans laquelle R¹(COOR³)ₘ(OH)ₚ dans la formule générale (1) est représenté par la formule générale (2). 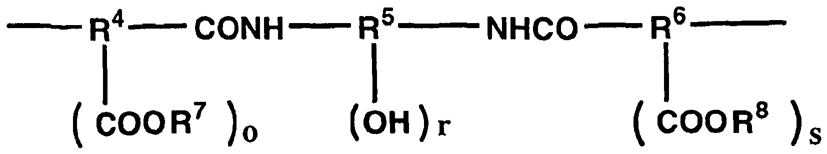 R⁴ et R⁶ représentent un groupe organique bivalent à quadrivalent comportant de 2 à 20 atomes de carbone, R⁵ un groupe organique trivalent à hexavalent comportant de 3 à 20 atomes de carbone, et R⁷ et R⁸ soit un atome d'hydrogène soit un groupe organique comportant de 1 à 20 atomes de carbone. Par ailleurs, o et s désignent un nombre entier dans la plage de 0 à 2, et r représente un nombre entier dans la plage de 1 à 4.

7. Composition de résine photosensible positive selon la Revendication 5, dans laquelle R²(OH)_{q} dans la formule générale (1) est au moins un motif représenté par l'une quelconque des formules générales (3) à (5). 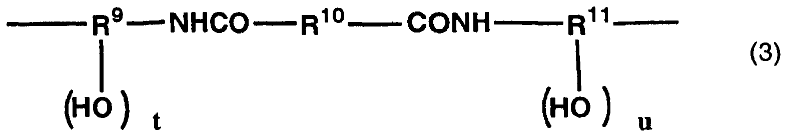 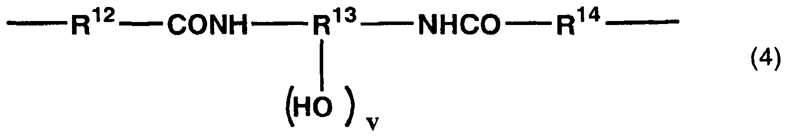 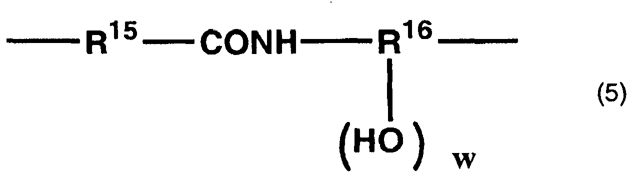 R⁹ et R¹¹ représentent un groupe organique trivalent à quadrivalent qui comprend de 2 à 20 atomes de carbone, R¹⁰ un groupe organique bivalent comprenant de 2 à 30 atomes de carbone, et t et u un nombre entier de 1 ou 2. R¹² et R¹⁴ représentent un groupe organique bivalent qui comprend de 2 à 20 atomes de carbone, R¹³ un groupe organique trivalent à hexavalent qui comprend de 3 à 20 atomes de carbone, et v un nombre entier de 1 à 4. R¹⁵ représente un groupe organique bivalent qui comprend de 2 à 20 atomes de carbone, R¹⁶ un groupe organique trivalent à hexavalent qui comprend de 3 à 20 atomes de carbone, et w un nombre entier de 1 à 4.

8. Composition de résine photosensible positive selon la Revendication 1, dans laquelle le composant (b) comprend un ou plusieurs composés choisis dans le groupe constitué des dérivés de coumarine, des dérivés de benzotriazole et des dérivés d'hydroxylbenzophénone.

9. Composition de résine photosensible positive selon la Revendication 1, dans laquelle le composant (b) comprend un composé choisi dans le groupe constitué de la Coumarine, de la Coumarine-4, de la 4-Hydroxycoumarine, de la 7-Hydroxycoumarine, du Sumisorb 130, du Sumisorb 200, du Zislizer M et du Zislizer O, dont les formules développées sont décrites ci-dessous :

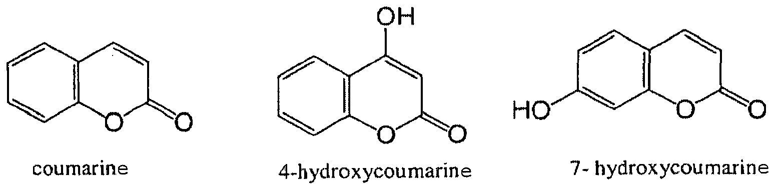

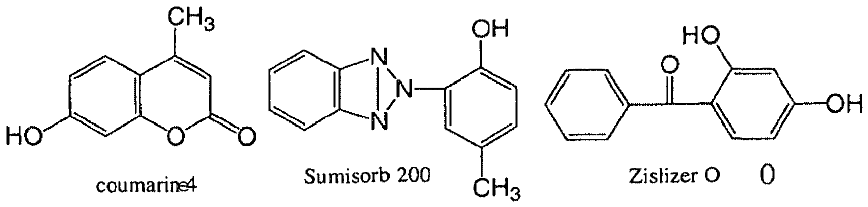

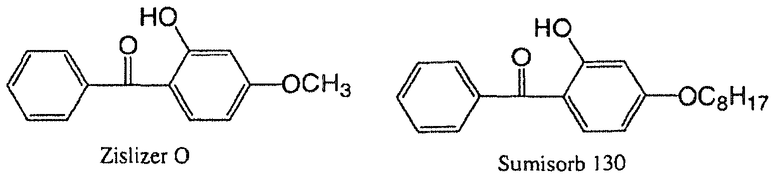

10. Motif en relief d'une résine résistante à la chaleur produite en exposant une composition de résine photosensible positive selon l'une quelconque des Revendications 1 à 9 à une lumière ultraviolette puis en la chauffant.

11. Capteur d'image à semi-conducteurs produit à partir d'un motif en relief de résine résistante à la chaleur selon la Revendication 10.
